(19) Europäisches Patentamt
European Patent Office
Office européen des brevets

(11) **EP 3 972 845 B1**

(12) **EUROPEAN PATENT SPECIFICATION**

(45) Date of publication and mention
of the grant of the patent:
**08.05.2024 Bulletin 2024/19**

(21) Application number: **20734440.9**

(22) Date of filing: **20.05.2020**

(51) International Patent Classification (IPC):
**B41J 2/045** (2006.01)          **B41J 2/14** (2006.01)
**C09D 11/00** (2014.01)

(52) Cooperative Patent Classification (CPC):
**B41J 2/04581; B41J 2/04551; B41J 2/04573;**
**B41J 2/04588; B41J 2/04595; B41J 2/14209;**
B41J 2002/14419; B41J 2002/14459; B41J 2202/12

(86) International application number:
**PCT/GB2020/051234**

(87) International publication number:
**WO 2020/234592 (26.11.2020 Gazette 2020/48)**

(54) **PIEZOELECTRIC DROPLET DEPOSITION APPARATUS OPTIMISED FOR HIGH VISCOSITY FLUIDS, AND METHODS AND CONTROL SYSTEM THEREFOR**

FÜR HOCHVISKOSE FLUIDE OPTIMIERTE, PIEZOELEKTRISCHE TRÖPFCHENABSCHEIDUNGSVORRICHTUNG UND VERFAHREN UND STEUERUNGSSYSTEM DAFÜR

APPAREIL DE DÉPÔT DE GOUTTELETTES PIÉZOÉLECTRIQUE OPTIMISÉ POUR DES FLUIDES À VISCOSITÉ ÉLEVÉE, ET PROCÉDÉS ET SYSTÈME DE COMMANDE ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.05.2019 GB 201907185**

(43) Date of publication of application:
**30.03.2022 Bulletin 2022/13**

(73) Proprietor: **Xaar Technology Limited**
**Huntingdon, Cambridgeshire PE29 6XX (GB)**

(72) Inventors:
• **JACKSON, Nicholas Marc**
  **Cambridge Cambridgeshire CB4 0XR (GB)**
• **CONDIE, Angus**
  **Cambridge Cambridgeshire CB4 0XR (GB)**
• **VOIT, Wolfgang**
  **Cambridge Cambridgeshire CB4 0XR (GB)**
• **COX, Andrew**
  **Cambridge Cambridgeshire CB4 0XR (GB)**
• **REDDISH, Michael**
  **Cambridge Cambridgeshire CB4 0XR (GB)**

(74) Representative: **Pitchford, James Edward**
**Mathys & Squire**
**The Shard**
**32 London Bridge Street**
**London SE1 9SG (GB)**

(56) References cited:
**EP-A1- 2 821 229          EP-A2- 3 330 329**
**WO-A1-2006/075477          US-A1- 2010 165 020**
**US-A1- 2011 080 456          US-A1- 2017 282 555**

**Description**

**FIELD OF INVENTION**

The present disclosure relates to a piezoelectric droplet deposition apparatus suitable for printing high viscosity fluids, a method of operating the apparatus and a control system therefor. The droplet deposition apparatus may be used with particular benefit in applications such as 3D printing and photopolymer jetting which require high molecular weight polymeric component fluids.

**BACKGROUND**

The inkjet industry is constantly evolving to cater to the needs of new and challenging applications, requiring new capabilities such as increased productivity and reduced cost.

It has been a long established principle that piezoelectric inkjet printheads are limited to depositing droplets of fluid having a viscosity below 30 mPa·s (Ohnesorge number $Oh$ < 1) due to the fluid resistance of flow through the nozzle, resulting in excessive drive voltage requirements or ink starvation from the inability to replenish the ink channel. This restricts the capability to print mechanically tough and flexible parts which require fluids such as resins that include high molecular weight polymer chains and have a viscosity far higher than conventional inkjet fluids.

Background art is provided in WO 2006/075477 A1, US 2010/165020 A1 and EP 3 330 329 A2.

WO 2006/075477 A1 discloses an inkjet head provided with a plurality of nozzles for jetting an ink, a plurality of ink flow paths which communicate with the plurality of nozzles and are arranged as grooves on a piezoelectric ceramic, and a common ink chamber for distributing the ink to the ink flow paths and filling the ink flow paths with the ink, wherein two or more ink supply ports are provided for supplying the common ink chamber with the ink from an ink supplying source.

US 2010/165020 A1 discloses an ink composition containing at least: a water-soluble organic solvent; a pigment; water; and a nonionic polymer thickener. The content of the water-soluble organic solvent is from 5 weight % to 30 weight % relative to the total amount of the ink composition. The ratio of $V_{high}/V_{low}$, in which $V_{high}$ represents 25°C viscosity (mPa·s) measured at a shear rate of $1.5 \times 10^5$ s$^{-1}$ and $V_{low}$ represents 25°C viscosity (mPa·s) measured at a shear rate of $3.0 \times 10^3$ s$^{-1}$, is from 0.70 to 0.95.

EP 3 330 329 A2 discloses an inkjet recording apparatus that includes a curable ink and a discharge head. The curable ink comprises a polymer having a polyester structural unit. The discharge head includes an individual liquid chamber including a circulation channel in which the curable ink is circulatable, and a nozzle from which the curable ink is dischargeable.

**SUMMARY**

Aspects of the invention are set out in the appended independent claims, while particular implementations of the invention are set out in the appended dependent claims.

The following disclosure describes, in one aspect, a droplet deposition apparatus comprising a droplet deposition head, a fluid supply and a controller; wherein: the droplet deposition head comprises one or more fluid chambers each having a nozzle, a fluid inlet path having a fluid inlet into the head, and ending in the one or more nozzles, and a fluid return path starting at the one or more nozzles and ending in a fluid return of the head; each fluid chamber comprises two opposing chamber walls comprising piezoelectric material and deformable upon application of an electric drive signal so as to eject a fluid droplet from the nozzle; the fluid supply is configured to supply a fluid to the fluid inlet at a differential pressure as measured between the fluid inlet and the fluid return; and the controller is configured to apply a drive signal to the piezoelectric chamber walls such that the nozzle or nozzles deposit droplets of a fluid having a viscosity in the range from 45 mPa·s to 130 mPa·s at a jetting temperature between 20°C and 90°C, and wherein the differential pressure applied by the fluid supply causes a fluid return flow into the fluid return at a rate of between 50 ml/min and 200 ml/min.

A method of operating the droplet deposition apparatus, and a control system for carrying out the method are also provided.

**BRIEF DESCRIPTION OF THE DRAWINGS**

Reference is now directed to the drawings, in which:

Figure 1 is a plot of viscosity against temperature for standard fluids D and E, development fluids A, B, C, F, G and K, and commercially available fluids like H, L and M;
Figure 2 is a plot of the rate of change of viscosity against temperature of the data of Figure 1;
Figure 3 is a plot of Weber number against Reynolds number for fluids A, B, C, D, E, F, G, H, K, L and M;

Figure 4 is an image of droplets in flight for the first drive mode using a high viscosity fluid;

Figure 5 is a schematic cross section of a low fluid resistance recirculation flow component of the printheads used to test the fluids;

Figure 6 is a schematic plan view taken along section D-D' of Figure 5;

Figure 7 is a three-dimensional view of the low fluid resistance piezoelectric printhead having a flow component according to the principles of Figures 5 and 6;

Figure 8 is a representation of a first mode of operating a droplet deposition apparatus illustrating chamber wall movement to produce a first pattern;

Figure 9a is an illustration of a drive pulse comprising sub droplet pulses suitable for the first drive mode illustrated in Figure 8;

Figure 9b is an illustration of drive pulses applied to the first five chamber walls of Figure 8;

Figure 10 is a representation of a first mode of operating a droplet deposition apparatus according to the same example as illustrated in Figure 8, but with different input data being used;

Figure 11 is a representation of a second mode of operating a droplet deposition apparatus illustrating chamber wall movement for 3-cycle printing;

Figure 12 is an illustration of drive pulses applied to each cycle of Figure 11;

Figure 13 is a block diagram of the droplet deposition apparatus described herein; and

Figure 14 is a block diagram of a control system for the droplet deposition apparatus described herein.

In the Figures, like elements are indicated by like reference numerals throughout.

## DETAILED DESCRIPTION

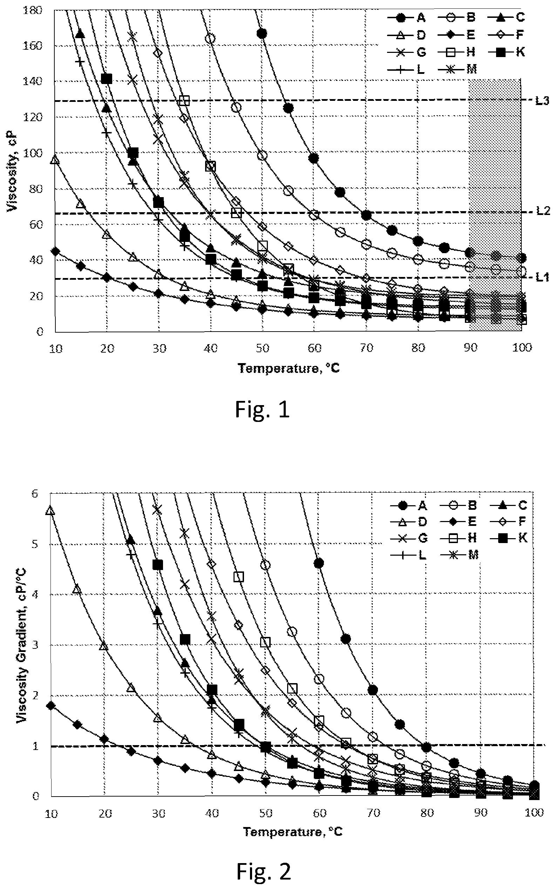

The functionality of the embodiments and their various implementations will now be described with respect to Figures 1-14.

The inventors have surprisingly found it possible, against expectations, to jet high viscosity fluids with certain types of piezoelectric inkjet printheads, provided certain specific conditions and combinations are employed. This allows stable ejection of fluids of high viscosity with Ohnesorge numbers greater than 1.

It was found that, contrary to expectations, a printhead may be designed with fluid recirculation past the nozzles having a differential pressure between its fluid inlet and fluid return and having a fluid resistance that is low enough to allow jetting of high viscosity fluids. In such printheads, it was found that recirculation past the nozzle allows sufficiently high fluid flow rates that ensure a constant supply of fluid to the pressure chamber and continuous nozzle replenishment, refilling the nozzle faster than viscous flow alone. The printheads tested have pressure chambers in which opposing chamber walls are comprised of piezoelectric material and these active walls are able to deform upon application of a voltage signal. Each wall is also an active wall for the neighbouring chamber, meaning each wall is shared between two chambers. The walls operate most efficiently in chevron shear-mode, and the printheads were found to be capable of jetting fluids with Ohnesorge numbers ($Oh$) greater than 1, and even greater than 2. In the printhead used to test the high viscosity fluids, pressure chambers are elongate and are open to the ink manifold at opposite ends, and opposing side walls deform to eject droplets in acoustic mode: two pressure pulses are generated from both ends of the chamber and they reinforce a droplet ejection pulse at the nozzle positioned at the centre of the chamber. This acoustic operation maximises the supply of fluid to the nozzle and minimises the energy required to eject a drop.

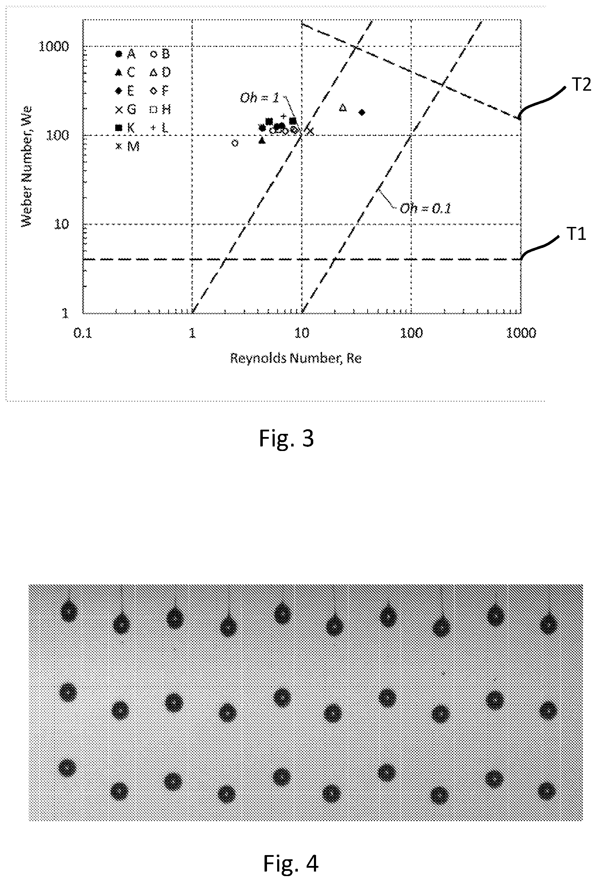

Additionally, a first drive mode was found to be particularly suited to jetting very high viscosity fluids. Using a near-resonant single-cycle operational "High Laydown (HL)" mode allowed jetting fluids in excess of 60 mPa·s and up to about 126 mPa·s, with Ohnesorge numbers $Oh$ > 2 as high as 2.5, while displaying stable drop formation with very little misting or satellites. In other examples, the "High Laydown (HL)" mode further allows jetting fluids up to about 130 mPa-s, with Ohnesorge numbers as high as 3 or as high as 4. Droplets imaged in flight for this mode of driving are shown in Figure 4. Furthermore, this first mode of printing enables the piezoelectric printheads used for the tests described herein to print entire layers of photopolymer of a thickness of up to 80 $\mu$m in a single pass at 423 mm/s scanning speed.

Further still, by elevating the jetting temperature, which is the temperature of the fluid when it passes through the fluid chambers, it is possible to jet fluids with viscosities in excess of 600 mPa·s at 30°C. This enables printing of specifically formulated fluids to achieve improved mechanical toughness and flexibility at high resolution and high speed, as well as potentially enabling some existing stereolithography 3D printing resins to be printed with piezoelectric droplet deposition heads.

## Fluid parameters

The fluids tested using the low fluid resistance inkjet printheads with open ended recirculation pressure chambers were analysed with respect to their properties against temperature (to assess properties at potential jetting temperature) and compared to standard inkjet fluids as follows. Figure 1 shows a plot of viscosity versus temperature for five different fluids labelled A, B, C, D and E, and corresponding to fluids listed in Table 3. Fluids A and B are high viscosity development fluids made by BASF and for which, at 30°C, the viscosity is 293 mPa·s (Fluid B) and 656 mPa·s (Fluid A). Fluids C, F, G, L and M, also made by BASF, have intermediate viscosities of 74 mPa·s, 156 mPa·s, 108 mPa·s, 63 mPa·s and 119 mPa·s, respectively, at 30°C. Fluid H, made by Delo, has an intermediate viscosity of 182 mPa·s at 30°C, while Fluid K has intermediate viscosity of 72 mPa·s at 30°C. Fluids D and E are standard inkjet fluids having a viscosity of 32 mPa·s or lower at 30°C. Fluid D, Sunjet ULX5832 Cyan, is a standard UV ink; Fluid E, Itaca MA5115, is a standard ceramic ink. A key of fluids is provided in Table 3.

Figure 1 further shows viscosity limits L1, L2 and L3. L1 indicates the 'traditional' limit of around 30 mPa·s above which conventional inkjet heads are believed to be unable to provide stable, good quality droplets. Above L1 the inventors have found, contrary to expectations, that fluids of much higher viscosities may be jetted: up to about L2 (65 mPa·s) with one drive mode, a 3-cycle mode, and up to around L3 (126 mPa·s) for another, single cycle, drive mode. In other examples L3 may be 130 mPa·s. The grey region above a fluid temperature of 90°C in Figure 1 indicates the maximum temperature beyond which the fluid may degrade and droplets fail to eject. This may for example be due to UV cured fluids curing thermally within the printhead. The values used to plot Figure 1 are also listed, for convenient reference in the later description, in Table 2. The actual value of degradation depends on the specific fluid and the fluid temperature.

From Figure 1 it can be seen that increasing the plateau of the fluid viscosity does not just shift the viscosity curve upwards in the plot of Figure 1, it also shifts it to higher temperatures, meaning that while the viscosity at the plateau is overall increased, the onset of the plateau itself is shifted to a higher temperature.

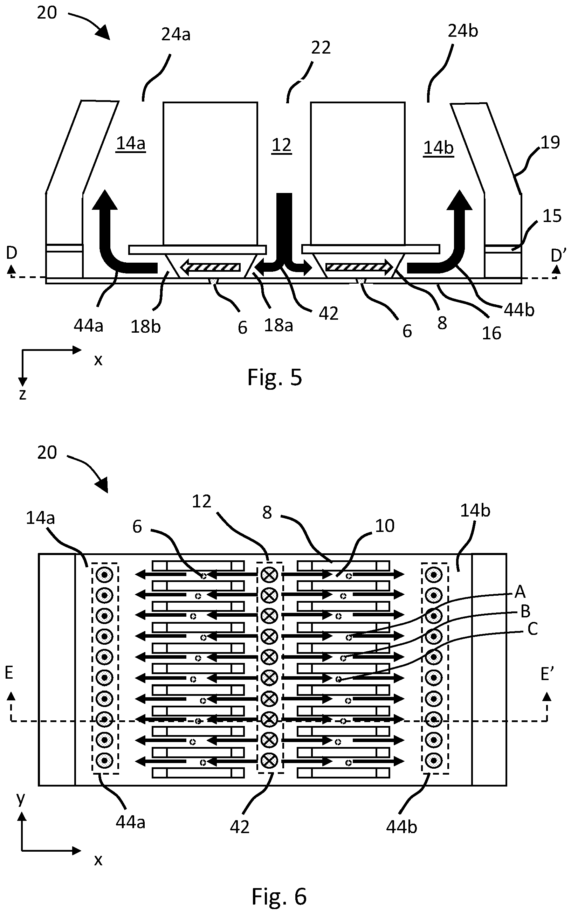

Two types of fluid recirculating printheads of the Xaar 1003 family were used to test high viscosity fluids, differing only in nozzle volumes and ejecting 7.5 pl sub-droplets ("GS6") and 15 pl ("GS12") sub-droplets for a first mode of printing (HL mode), and in a second mode of printing ejecting 6 pl sub-droplets ("GS6") and 12 pl ("GS12") sub-droplets (3-cycle mode). The fluid flow path for the two printheads is otherwise identical. Each printhead has 1000 nozzles, one per pressure chamber, arranged in two parallel rows of 500 nozzles each. The pressure chambers are elongate and open to the fluid flow at opposite ends of the pressure chamber without a change in cross section from that of the pressure chamber. Each pressure chamber is bounded at opposing elongate sides by chamber walls comprising piezoelectric material. Upon actuation by a drive pulse of a drive signal, these walls deform to cause ejection of a droplet from the nozzle. This construction is also referred to as 'shared wall', referring to each piezoelectric wall being shared between two neighbouring chambers. The piezoelectric material is poled in a direction perpendicular to the direction of elongation of the chamber and perpendicular to the row direction of the nozzles, i.e. in the case of the Xaar 1003 head in the direction of the nozzle axis. This causes a shear mode deformation. This mode is made most efficient by constructing the piezoelectric walls such that they are formed of an upper portion poled in one direction, and a lower portion poled in the opposite direction, such that the deformation is 'chevron shaped' when viewed along the cross section of the chamber perpendicular to the direction of elongation. The Xaar 1003 printhead series is able to operate in an efficient shared-wall "chevron" shear mode. The flow path of the Xaar 1003 head will now be described in more detail with respect to Figures 5, 6 and 7.

**Recirculation flow path**

Regarding open ended pressure chamber recirculation, examples of such printheads were shown and described in WO 00/38928. WO 00/38928 teaches that fluid may be fed into an inlet manifold and returned via a return manifold, with the manifolds being common to and connected via each pressure chamber, so as to generate fluid flow through each chamber and thus past each nozzle during printhead operation.

The fluid path of a printhead 30 such as the Xaar 1003 is schematically illustrated in Figures 5 and 6, where Figure 5 is a cross section through the flow component 20 bisecting a pressure chamber 10 along the elongate direction of the chamber, and along the section E-E' indicated in Figure 6. For this type of printhead as the Xaar 1003, this is the direction perpendicular to the row of nozzles 6. Figure 6 meanwhile is a plan view of the flow component along section D-D' of Figure 5, i.e. looking up into the flow component with the nozzle plate 16 removed.

Fluid enters the flow component 20 of the printhead via an inlet port 22 provided in a manifold portion 19 of the flow component 20. The inlet port 22 is common to the two rows of nozzles 6. In Figure 5, the row of nozzles 6 extends into the page (here direction y). The fluid then travels as inlet flow 42 through common inlet 12 and divides into two flows flowing in opposite directions (here along x) through pressure chambers 10 (indicated in Figure 6) of different rows. The pressure chambers are shown bounded by wall 8 on one side, and have an identical wall on the other side.

A manufacturing technique for forming pressure chambers 10 and electrodes and contacts to the electrodes is described in detail for example in WO 00/29217. Briefly, chambers 10 are machined in a base component of piezoelectric material so as to define piezoelectric channel walls 8. The two rows of chambers are formed in respective strips of piezoelectric material which are bonded to a planar surface of substrate 15. To address each chamber wall, electrodes are provided on the walls of the chambers, thereby to form actuators from chamber walls 8, as known e.g. from EP 0 277 703 A1, so that electrical signals may be selectively applied to the walls. A break in the electrodes allows the chamber walls of each row to be operated independently by means of electrical signals applied via electrical inputs (not shown). The chamber walls may thus act as actuator members that can cause droplet ejection. Substrate 15 is formed with conductive tracks (not shown), which are electrically connected to the respective chamber wall electrodes, and which extend to the edge of the substrate 15 where respective drive circuitry (integrated circuits) for each row of chambers is located.

The arrangement of the pressure chambers 10 is identical between the two rows of nozzles. The fluid travels through each pressure chamber, and exits the chambers to flow as return flow 44a into a common return 14a for one row and as return flow 44b into a common return 14b for the other row.

Each pressure chamber 10 has a nozzle 6 at or near its centre, provided in the nozzle plate 16 that bounds the chambers on one side. This is more easily seen in Figure 6, which shows a portion of the two rows of nozzles, which in the Xaar 1003 extend to over 500 nozzles each. In addition, Figure 6 shows the nozzles of each row in a 3-cycle mode pattern. Three neighbouring nozzles are successively offset along the elongate direction of the pressure chamber, in a repeating pattern for subsequent nozzle groups of three nozzles. The nozzles in each group of three may be referred to as the A, B and C group nozzles. This grouping will be further described below with respect to a second drive mode, the 3-cycle drive mode of a shared wall printhead.

Figure 6 shows each chamber 10 bounded by chamber walls 8 on each side. The inlet 12 is shown with flow indicators of the common flow 42 in the droplet ejection direction (along z), which then splits to flow through each chamber 10. The return flow exits each chamber 10 and combines with the other return flows from the same row to form return flow 44. Return flow 44 passes through the common returns 14 and into the common return port 24.

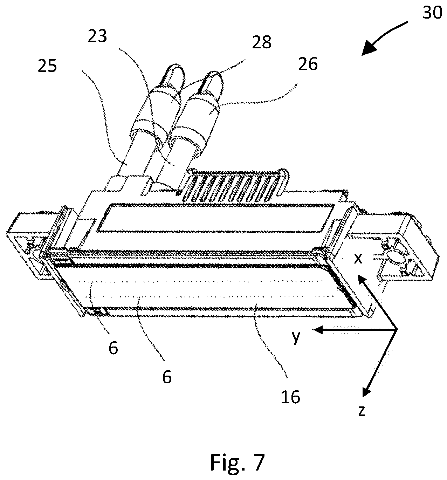

When the chamber walls are provided with a drive signal, the walls 8 deform and a droplet is ejected from the nozzle 6. The flow past the nozzle contributing to return flow 44 is greater than the flow ejected from the nozzle 6 in the form of a droplet, allowing the printhead to operate in 'recirculation' mode. For this, a positive pressure is applied to the fluid entering the inlet port 22 via an inlet pipe 23 (shown in Figure 7), and a negative pressure is applied to the fluid returning via return port 24 and return pipe(s) 25. In the case of the Xaar 1003, the two return ports 24a, 24b connect downstream to flow into one combined return pipe 25. The positive and negative pressure may, for example, be provided by an external fluid supply connected to the inlet and return pipes of the printhead 30. Fluid recirculation as referred to herein is provided when the fluid flow rate through a chamber 10 is higher than the rate of ink ejection from the chamber and may, in some cases, be five or ten times that rate.

It should be noted that the cross section of the (unactuated) pressure chamber remains constant and that each "open end" 18a, 18b of each pressure chamber 10 presents an opening into the pressure chamber 10 that has the same cross section as the pressure chamber itself. For the Xaar 1003 printhead family, this cross section is 0.0225 mm$^2$ for a chamber length of 1.8 mm. The resulting fluid resistance of the entire printhead with its two parallel row manifolds is around 0.8 mbar/(ml·min) for Xaar 1003 printheads GS6 and GS12. This means that each manifold row resistance is 1.6 mbar/(ml·min) and each chamber has a fluid resistance of 800 mbar/(ml·min).

Figure 7 shows the printhead 30 in a three-dimensional perspective from below, so that nozzle plate 16 with two rows of nozzles 6 can be seen, and the inlet pipe 23 and combined return pipe 25 of the flow component 20. The pipes are shown with covers 26, 28, for example used during shipping.

Next, a first and second drive mode will be described that were found to be suitable for jetting high viscosity fluids from a recirculation head such as the Xaar 1003.

**High Laydown / first mode**

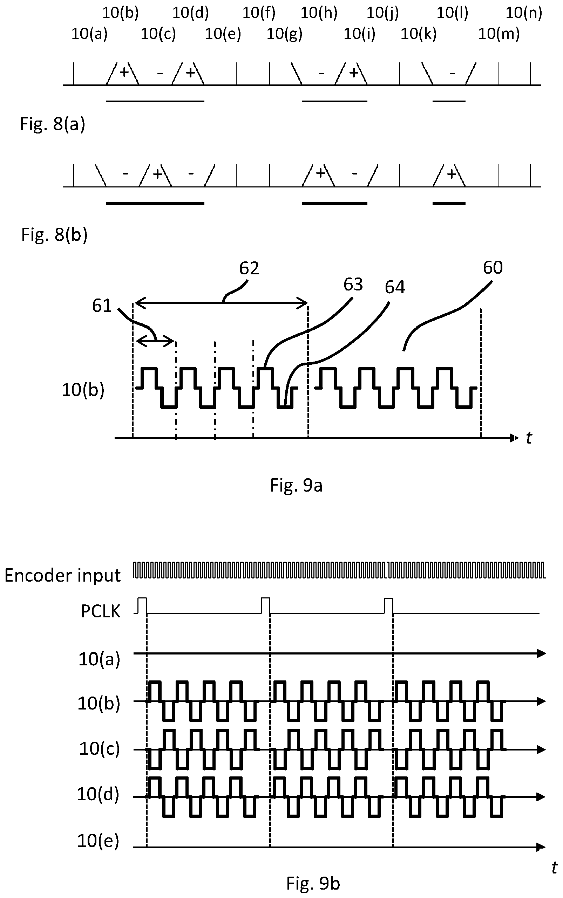

Figures 8(a) and 8(b) show a method according to a first drive mode, previously described in detail in WO 2018/224821 and WO 2019/058143. In this mode, a sub-droplet is ejected from each pressure chamber 10 for which both walls move in opposing senses inwards within the same drive signal. As a result, the droplets ejected within the drive signal duration all land along the same pixel line on the media. As indicated by emboldened horizontal lines in Figures 8(a) and 8(b), based on input data, certain of the chambers within the nozzle row are assigned as firing chambers during application of a drive signal (in the example shown, chambers 10(b), 10(c), 10(d), 10(h), 10(i), 10(l)) and will deposit droplets during application of the drive signal, while the remaining chambers (in the example shown, chambers 10(a), 10(e), 10(f), 10(g), 10(j), 10(k), 10(m), 10(n)) are assigned as non-firing chambers. As is apparent from the drawing, this assignment results in bands of one or more contiguous firing chambers, indicated by the emboldened horizontal lines, separated by bands of one or more contiguous non-firing chambers for one cycle of the drive signal.

With this assignment having been carried out, the walls of certain of the chambers are then actuated by the drive signal. Figures 8(a) and 8(b) show the head at respective points in the actuation cycle of the drive signal. More particularly, Figure 8(a) shows a point in the actuation cycle where the walls are at one extreme of their motion, whereas Figure 8(b) shows the point a fraction of a cycle later, when the walls are at the opposite extremes. The drive signal respective Figures 8(a) and 8(b) are illustrated in Figure 9.

Figure 9(a) shows a close up of a drive signal 60 made up of sub droplet pulses 61. Four sub droplet pulses are shown for one pixel period 62, over which the four sub droplets form a drop to land in a pixel along the pixel line. For the first mode or high laydown mode, each sub droplet pulse may cause ejection from neighbouring chambers. For example for chamber 10(b), the first part of a sub droplet pulse 63 to one wall of chamber 10(b), for example the shared wall between 10(b) and 10(c), and to the other wall, i.e. the shared wall of chambers 10(b) and 10(a), causes the walls of chamber 10(b) to move inward, as shown in Figure 8(a), and chamber 10(b) ejects a sub droplet. The second part of the sub droplet pulse 64 to one wall of chamber 10(b), for example the shared wall between 10(b) and 10(c), and a similar pulse applied to the shared wall between chamber 10(c) and 10(d), causes the shared wall between 10(b) and 10(c) to move outwards of chamber 10(b), so that both walls of chamber 10(c) move inward, as shown in Figure 8(b), and chamber 10(c) ejects a sub droplet, while chamber 10(b) does not eject a sub droplet. The next sub droplet pulse repeats the wall motion until four sub droplets in total are ejected to form the drop that is deposited into the pixel on the medium. Figure 9(b) shows example drive pulses to chambers 10(a) to 10(e) of Figure 8, where firing chambers 10(b) to 10(d) receive drive signals, while non-firing chambers 10(a) and 10(e) do not. It can be seen that the drive signal for chamber 10(c) is opposite to the drive signal for chambers 10(b) and 10(d) as shown in Figures 8(a) and 8(b). It also illustrates the timing of drive signals sent to each of the chambers. The drive signal is initiated by a pixel clock trigger PCLK. The pixel clock is related to the encoder of the moving mechanism of the printing medium, and allows the controller of the droplet deposition apparatus to determine the position of the pixel line on the medium and to coordinate the droplet ejection from the nozzle of the pressure chambers as a result of application of the drive signal. Upon receiving the pixel clock trigger, the controller that sends the drive signal to the chambers causes the chambers to receive the drive signal. After a predetermined time from initiating the drive signal for a first pixel line, where the predetermined time is related to the medium speed and the chamber acoustics, the drive signal is sent again to cause the nozzles to eject droplets into the second pixel line.

As is apparent from comparing the two drawings in Figure 8, for each one of the firing chambers 10(b), 10(c), 10(d), 10(h), 10(i), 10(l), the walls move with opposing senses.

As to the non-firing chambers, two different types of behaviour for their walls may be observed: for some of the non-firing chambers, specifically, those adjacent a band of firing chambers (in the example shown, chambers 10(a), 10(e), 10(g), 10(j), 10(k), 10(m)), one wall is moved, while the other remains stationary; for other non-firing chambers, specifically those not adjacent a band of firing chambers (in the example shown, chambers 10(f), 10(n)), both walls remain stationary.

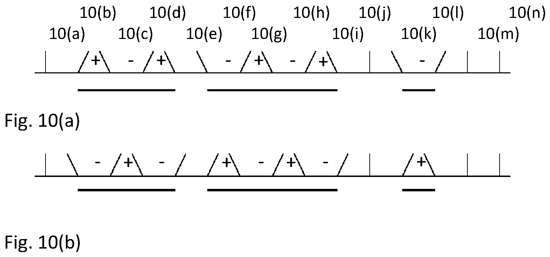

Attention is next directed to Figures 10(a) and 10(b), which show a first mode according to the same example as Figures 8(a) and (b), when utilised to deposit droplets in accordance with different input data. As with Figures 8(a) and 8(b), Figures 10(a) and 10(b) show the head at respective points in the actuation cycle. As may be seen from Figures 10(a) and 10(b), based on the new input data, different chambers 10 have been assigned as firing chambers and non-firing chambers. More particularly, it may be noted that the assignment has resulted in a band of non-firing chambers that consists of only a single non-firing chamber, specifically chamber 10(e).

As is apparent from comparing the two drawings, for each one of the firing chambers 10(b), 10(c), 10(d), 10(f), 10(g), 10(h), 10(i), 10(l), the walls move with opposing senses, as in Figures 8(a) and 8(b).

However, with the non-firing chambers, three (as opposed to two) different types of behaviour for their walls may be identified: for some of the non-firing chambers, specifically, those adjacent a band of firing chambers (in the example shown, chambers 10(a), 10(j), 10(k), 10(m)), one wall is moved, while the other remains stationary; for other non-firing chambers, specifically those not adjacent a band of firing chambers (in the example shown, chamber 10(n)), both walls remain stationary; for still others, specifically, the chamber 10(e) in the single chamber wide band of non-firing chambers, the walls move with the same sense.

It may be understood that moving the walls for each firing chamber as shown in Figures 8 and 10 causes the release of one or more droplets from the chamber in question upon application of one or more actuation pulses. The resulting droplets form bodies of fluid disposed on a line on the medium, with the bodies of fluid being separated (at least instantaneously upon landing - the fluid bodies may merge on the medium) on this line by respective gaps for each of the bands of non-firing chambers. It should be understood that the size of each such gap will thus generally correspond in size to the width of the respective band of non-firing chambers.

As can be seen from the actuation sequences in Figures 8 and 10, for example, if the drive signal applied in Figure 10 were to directly follow the drive signal in Figure 8, some non-firing chambers may only require a small wall movement to provide a transition from a non-firing chamber to a firing chamber. In addition, it is possible for a large number of the walls of the non-firing chambers to remain stationary. This may improve the lifetime of the head, by reducing the number of wall movements carried out by the walls in order to achieve a certain laydown density of droplet fluid on the substrate.

The methods illustrated in Figure 8, 9 and 10 represent a high laydown drive mode, providing a high rate of throughput. The firing chambers may be actuating at or close to the resonant frequency and thus achieve a "pumping power" (the amount of droplet fluid deposited per second for each inch of the width of the head) significantly higher than 197 μl/(s.cm) (500 μl/(s.inch)), in several cases higher than 295 μl/(s.cm) (750 μl/(s.inch)), and potentially as high as 394 μl/ (s.cm) (1000 μl/(s.inch)). Both the reduced drive voltage and the more efficient use of the actuating walls improves the life of the head.

Printheads have a maximum acceptable drive voltage, thus limiting the maximum impulse able to be imparted on the fluid and therefore limiting a maximum viscosity that is possible to eject from the nozzles. The lower drive voltage resulting from the near-resonant single-cycle High Laydown drive mode (the first mode) means that the viscosity can be increased further before reaching the voltage limit of the printhead.

Applying drive signals that move opposing walls inwards for each firing chamber as shown in Figures 8 and 10 causes the release of one or more sub droplets from the firing chamber. The resulting sub droplets form bodies of fluid disposed on a pixel line on the medium, with the bodies of fluid each landing in their respective pixels of the pixel line and being separated (at least instantaneously upon landing - the fluid bodies may merge on the medium) on this line by respective gaps between each firing band of the bands of non-firing chambers. It should be understood that the size of each such gap will thus generally correspond in size to the width of the respective band of non-firing chambers.

In order that the thus-deposited bodies of fluid lie on a line on the medium, it will often be convenient for the actuations of the firing and non-firing chambers to overlap in time. This is, though, not essential, for example in cases where the nozzles of the head are offset in some manner such as in ejection groups A, B, C indicated in Figure 6. Further, in some cases, they may be synchronised such that the actuations for all chambers begin at the same time (though it would of course also be possible for them to be synchronised to end at the same time).

**3-cycle mode / second mode**

In a second drive mode, the printhead is driven in a 3-cycle mode. The nozzles of each row are arranged in groups of three. The nozzles in each group are offset in a direction perpendicular to the row direction. Nozzles in different groups having the same offset distance with respect to the row direction are in the same ejection group (cycle group), this providing three ejection groups A, B and C, as indicated in Figure 6 by nozzles of group A, B and C. In Figure 6 the offset is along x. During printing, the nozzles eject droplets into a pixel line as the printhead moves relative to the media in a printing direction (in Figure 6 this might be along the x-direction) such that the group located furthest downstream with respect to the printing direction is actuated first, the interim group is actuated second, and the group located furthest upstream of the printing direction is actuated last. The timing between actuations for each group relates to the media speed and the acoustic properties of the pressure chamber.

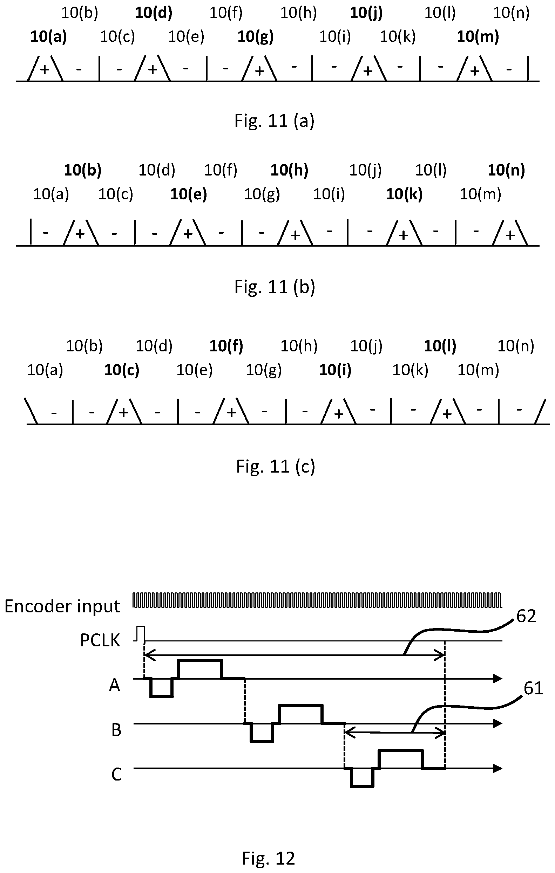

In 3-cycle printing of the second drive mode, a droplet is ejected when both walls of a pressure chamber move inwards to create a pressure pulse along the chamber. The neighbouring chambers experience a low pressure since their opposite chamber wall remains stationary. In Figure 11(a), the chamber wall movement for "Group A" of the first cycle is shown. For chambers 10(a) to 10 (n), every third chamber is actuated and its walls move inwards. These are chambers 10(a), 10(d), 10(g), 10(j) and 10(m) shown in bold numerals. These chambers deposit droplets into respective pixels of the pixel line. The second cycle, group B, is actuated next, as shown in Figure 11(b) by chambers 10(b), 10(e), 10(h), 10(k) and 10(n). These B-group chambers now deposit droplets into respective pixels of the same pixel line. Meanwhile the remaining chambers experience low pressure (causing intake of fluid). The final cycle, the C-cycle, is shown in Figure 11(c) for actuated chambers 10(c), 10(f), 10(i), and 10(l) shown in bold numerals, during which these chambers are actuated to deposit droplets into respective pixels of the same pixel line. The pixel line is now fully printed.

Figure 12 illustrates the timing of drive pulses sent to each of the chambers of group A, B and C. As before, the drive signal applied over the pixel period 62 is initiated by a pixel clock trigger PCLK. Upon receiving the pixel clock trigger, the controller causes the chambers of Group A to receive a sub droplet pulse 61 (shown for Group C but identical in shape for all other groups). After a predetermined time from initiating the Group A sub droplet pulse, where the predetermined time is related to the medium speed and the chamber acoustics, the sub droplet pulse is sent to group B. After a further lapse of the predetermined time from initiation of the sub droplet pulse for Group B, the sub droplet pulse is sent to group C. If the medium speed is unchanged, the predetermined time remains constant. Each of the three cycles causes the ejection of one sub droplet per chamber. To complete printing into the pixel line, the cycle is repeated for the required number of sub droplets for that pixel.

**Jetting tests**

Xaar 1003 GS6 and GS12 printheads were used in the first and second mode to test various standard fluids against development inks of high to very high jetting viscosity. The ejection flow rate through the nozzles is determined by the number of sub-droplets ejected.

With the GS12 head, which can eject sub droplets of volume of 15 pl each in High Laydown (HL), or first, mode, printing full duty with 4 sub droplets per pixel (i.e. a total drop volume of 60 pl) provides an ejection rate of about 100 ml/min for a fluid of viscosity of 65 mPa·s at a pixel clock frequency of 28 kHz when all nozzles are firing (or 100% duty).

Reliable printing conditions were found at a low flow ratio of 1.5:1 of the recirculation volume flow rate (recirculation rate) to drop ejection volume flow rate (ejection rate). This corresponds to a recirculation rate of 150 ml/min. The low fluid resistance path of the Xaar 1003 printhead requires a relatively low differential pressure $DP$ ($DP$ being the difference in pressure between inlet and return pipes 23, 25 to the printhead) of about 529 mbar to achieve the recirculation flow rate of 150 ml/min for this 65 mPa·s fluid. For a viscosity of 97 mPa·s and the same recirculation flow rate of 150 ml/min, the $DP$ needs to be 790 mbar. A higher end of differential pressure to be applied, such as including 790 mbar, may necessitate a higher specification of fluid supply components to reduce the variability in the pressure applied, the design of such a fluid supply being within standard engineering capability. The values are summarised in Table 1A for fluid A, which allow one to compare standard inkjet fluid such as fluid D (Sunjet ULX5832), with a viscosity of 32 mPa·s at 30°C, with non-traditional inkjet fluids such as fluids A (BASF high viscosity development fluid), C (PEG 400), K (high viscosity development fluid), H (Delo Katiobond OM6600), L (BASF Ultracur3D WS07) and M (BASF Ultracur3D ST30 LV).

As can be observed in Table 1A, fluids A, C, K, H, L and M have viscosities higher than traditional inkjet fluids. Fluid A has the highest viscosity of 656 mPa·s at 30°C, followed by fluid H with 182 mPa·s at 30°C. Fluids C, K, L and M have, at 30°C, viscosities within the range of 63 to 87 mPa·s. Fluid A was heated to different jetting temperatures of 60°C and 70°C to achieve viscosities of 97 mPa·s and 65 mPa·s respectively.

Turning to the GS6, when driven in the first mode this head deposits a lower total drop volume per pixel per nozzle of 30 pl, resulting from 4 sub-drops at 7.5 pl, i.e. half the total drop volume of the GS12 using the first drive mode. At the same print frequency of 28 kHz, the ejection flow rate is therefore halved to about 50 ml/min at 100% duty (when all nozzles are firing) for the GS6 in comparison to the GS12, and similarly a flow ratio of 1.5:1 corresponds to a recirculation flow rate of about 75 ml/min. For a fluid of viscosity of 65 mPa·s, the differential pressure required to achieve this flow rate is about 250 mbar. For a fluid of viscosity of 97 mPa·s the DP required is 370 mbar, and for a viscosity of 126 mPa·s the DP required is 475 mbar. These values are summarised in Table 1B, for fluids A and B. Fluid A as before provides viscosities of 65 mPa·s and 97 mPa·s at jetting temperatures of 70°C and 60°C respectively, and fluid B was used to provide a viscosity of 126 mPa·s at jetting temperature of 45°C (lowered from a viscosity of 293 mPa·s at 30°C). Fluid B is also a high viscosity development fluid.

Turning to results from using the 3-cycle mode, or second mode, the sub droplet volumes for the GS6 and GS12 heads are slightly lower compared to the first mode and the print frequency is only 6 kHz due to 3-cycle driving compared to the first mode at 28 kHz. In 3-cycle mode, seven sub droplets (more than with the first, HL, mode) were jetted to form a total drop volume deposited into a pixel.

For the GS12, the sub droplets have a volume of 12 pl each, or a total drop volume of 84 pl; for the GS6, the sub droplets have volumes of 6 pl and the total drop volume per pixel is 42 pl. For a 5:1 recirculation ratio for the GS12 and a 10:1 recirculation ratio for the GS6, this again equates to a recirculation rate of 150 ml/min and an ejection rate of about 30 ml/min.

Fluids A, C, D, H, K, L and M were tested with the GS12. Fluids A and K are development fluids of viscosity much higher than traditional inkjet fluids like Fluid D: Fluid A provides a viscosity of 656 mPa·s while fluid K provides a viscosity of 72 mPa·s at 30°C, compared to 32 mPa·s at 30°C for fluid D (Sunjet ULX5832 Cyan). Different fluids require different differential pressures DP to keep the recirculation rate at 150 ml/min. For example, fluid A requires a differential pressure DP of about 494 mbar to supply a recirculation rate of 150 ml/min at a fluid viscosity of 65 mPa·s for a temperature of 70°C. On the other hand, fluid K has a difference pressure of about 403 mbar at a fluid viscosity of 53 mPa·s for a temperature of 35°C.

Further examples are: fluid C (PEG400) which has a differential pressure of 774 mbar at a fluid viscosity of 95 mPa·s for a temperature of 25°C; fluid H (Delo Katiobond OM6600) which has a differential pressure of 502 mbar at a fluid viscosity of 66 mPa·s for a temperature of 45°C; fluid L (BASF Ultracur3D WS07) which has a differential pressure of 479 mbar at a fluid viscosity of 63 mPa·s for a temperature of 30°C; and fluid M (BASF Ultracur3D ST30 LV) which has a differential pressure of 742 mbar at a fluid viscosity of 91 mPa·s for a temperature of 27°C.

In contrast, fluid D was jetted at 45°C and viscosity of 17 mPa·s. With the same settings of frequency and number of sub droplets per pixel, a differential pressure DP of just 129 mbar is required to supply 150 ml/min recirculation rate.

A summary of jettable fluids and their properties for the second mode is provided in Table 1A for the GS12 printhead and in Table 1B for the GS6 printhead.

Table 1A: GS12

| mode | Fluid | $\eta_{jetting}$, mPa·s | DP, mbar | Flow ratio | Flow rate, ml/min | $T_{jetting}$, °C | $\eta_{30°C}$, mPa·s | Ejection rate, ml/min | Sub-droplet volume, pl | Total Drop volume, pl |
|---|---|---|---|---|---|---|---|---|---|---|
| 2 | D | 17 | 129 | 5:1 | 150 | 45 | 32 | 30 | 12 | 84 |
| 2 | A | 65 | 494 | 5:1 | 150 | 70 | 656 | 30 | 12 | 84 |
| 2 | H | 66 | 502 | 5:1 | 150 | 45 | 182 | 30 | 12 | 84 |
| 2 | K | 53 | 403 | 5:1 | 150 | 35 | 72 | 30 | 12 | 84 |
| 2 | L | 63 | 479 | 5:1 | 150 | 30 | 63 | 30 | 12 | 84 |
| 1 | A | 65 | 529 | 1.5:1 | 150 | 70 | 656 | 100 | 15 | 60 |
| 1 | A | 97 | 790 | 1.5:1 | 150 | 60 | 656 | 100 | 15 | 60 |
| 1 | C | 95 | 774 | 1.5:1 | 150 | 25 | 74 | 100 | 15 | 60 |
| 1 | K | 88 | 717 | 1.5:1 | 150 | 27 | 72 | 100 | 15 | 60 |
| 1 | L | 63 | 513 | 1.5:1 | 150 | 30 | 63 | 100 | 15 | 60 |
| 1 | M | 91 | 742 | 1.5:1 | 150 | 27 | 87 | 100 | 15 | 60 |

Table 1B: GS6

| mode | Fluid | $\eta_{jetting}$, mPa·s | DP, mbar | Flow ratio | Flow rate, ml/min | $T_{jetting}$, °C | $\eta_{30°C}$, mPa·s | Ejection rate, ml/min | Sub-droplet volume, pl | Total Drop volume, pl |
|---|---|---|---|---|---|---|---|---|---|---|
| 2 | D | 17 | 130 | 10:1 | 150 | 45 | 32 | 15 | 6 | 42 |
| 1 | A | 65 | 250 | 1.5:1 | 75 | 70 | 656 | 50 | 7.5 | 30 |
| 1 | A | 97 | 370 | 1.5:1 | 75 | 60 | 656 | 50 | 7.5 | 30 |
| 1 | B | 126 | 475 | 1.5:1 | 75 | 45 | 293 | 50 | 7.5 | 30 |

Table 2: Figure 1 data

| T,°C | $\eta$ at 0.6 Pa, mPa·s | | | | | | | | | | |
|---|---|---|---|---|---|---|---|---|---|---|---|
| Fluid | A | B | C | D | E | F | G | H | K | L | M |
| 10 | 3004 | 1052 | 225 | **96** | **45** | 485 | 327 | 738 | 292 | 207 | 477 |
| 15 | 2042 | 757 | 167 | **72** | 37 | 362 | 246 | 519 | 202 | 151 | 332 |
| 20 | 1392 | 548 | **126** | **55** | 30 | 272 | 185 | 365 | 142 | **111** | 234 |
| 25 | 952 | 399 | **95** | 42 | 25 | 205 | 141 | 258 | **100** | **83** | 165 |
| 30 | 656 | 293 | **74** | 32 | 21 | 156 | **108** | 182 | **72** | **63** | **119** |
| 35 | 455 | 217 | **58** | 26 | 18 | **119** | 83 | **129** | 53 | **48** | **87** |
| 40 | 320 | 164 | **47** | 21 | 16 | **93** | **65** | 92 | **45** | 38 | **65** |
| 45 | 229 | **126** | 39 | 17 | 14 | **73** | **52** | **66** | 32 | 30 | **51** |
| 50 | 167 | **98** | 33 | 15 | 12 | **58** | 42 | **48** | 26 | 25 | 40 |
| 55 | **125** | **79** | 28 | 13 | 11 | **48** | 34 | 35 | 22 | 21 | 34 |
| 60 | **97** | **65** | 25 | 12 | 10 | 40 | 29 | 26 | 19 | 18 | 29 |

(continued)

| T,°C | $\eta$ at 0.6 Pa, mPa·s | | | | | | | | | | |
|------|------|------|------|------|------|------|------|------|------|------|------|
| **Fluid** | **A** | **B** | **C** | **D** | **E** | **F** | **G** | **H** | **K** | **L** | **M** |
| 65 | **78** | **55** | 23 | 11 | 9 | 34 | 25 | 20 | 17 | 17 | 26 |
| 70 | **65** | **48** | 21 | 10 | 9 | 29 | 22 | 15 | 16 | 15 | 23 |
| 75 | **56** | 43 | 20 | 9 | 8 | 26 | 20 | 12 | 15 | 14 | 22 |

Table 3: Fluid key

| Fluid | Fluid | $\eta$ at 30°C; mPa·s |
|-------|-------|------|
| A | BASF High Viscosity Development Fluid | 656 |
| B | BASF High Viscosity Development Fluid | 293 |
| C | PEG400 | 74 |
| D | Sunjet ULX5832 Cyan | 32 |
| E | Itaca MA5115 Brown | 21 |
| F | BASF High Viscosity Development Fluid | 156 |
| G | BASF High Viscosity Development Fluid | 108 |
| H | Delo Katiobond OM6600 | 182 |
| K | High Viscosity Development Fluid | 72 |
| L | BASF Ultracur3D WS07 | 63 |
| M | BASF Ultracur3D ST30 LV | 119 |

Accordingly, a droplet deposition apparatus 1 is provided comprising a droplet deposition head 30, a fluid supply 40 and a controller; wherein the droplet deposition head comprises one or more fluid chambers 10 each having a nozzle 6, a fluid inlet path having a fluid inlet 23 into the head, and ending in the one or more nozzles, and a fluid return path starting at the one or more nozzles and ending in a fluid return 25 of the head. Each fluid chamber 10 comprises two opposing chamber walls 8 comprising piezoelectric material and deformable upon application of an electric drive signal 60 so as to eject a fluid droplet from the nozzle 6. The fluid supply 40 is configured to supply a fluid to the fluid inlet 23 at a differential pressure as measured between the fluid inlet 23 and the fluid return 25. The controller is configured to apply a drive signal to the piezoelectric chamber walls such that the nozzle or nozzles deposit droplets of a fluid having a viscosity in the range from 45 mPa·s to 130 mPa·s at a jetting temperature between 20°C and 90°C, and wherein the differential pressure applied by the fluid supply 40 causes a fluid return flow into the fluid return at a rate of between 50 ml/min and 200 ml/min.

The Xaar 1003 printhead has been operated with fluid at a jetting temperature of 90°C, such as a hot melt wax. As stated before, the upper limit of the jetting temperature and beyond which a fluid degrades and becomes unjettable or unreliable depends on the specific fluid properties.

In some implementations of the droplet deposition apparatus, the ratio of the recirculation volume flow rate (recirculation rate) to drop ejection volume flow rate (ejection rate) may be 1.5:1 to ensure reliable printing conditions. In addition, this ratio of 1.5:1 may correspond to a recirculation rate of 150 ml/min.

In some implementations, the viscosity of the fluid may be 65 mPa·s, requiring a differential pressure DP (DP being the difference in pressure between inlet and return pipes 23, 25 to the printhead) of about 529 mbar to achieve the recirculation flow rate of 150 ml/min for this 65 mPa·s fluid. In alternative implementations, the viscosity of the fluid may be 97 mPa·s, requiring a differential pressure DP of 790 mbar.

The differential pressure may be applied by applying a positive pressure to the fluid inlet 23 and a negative to the return 25. For a two nozzle row printhead, the two return ports 24a, 24b may be combined downstream to flow into one combined return 25.

In some arrangements, the fluid supply 40 may be configured to heat the fluid to a temperature in the range of 20°C to 90°C and to provide the heated fluid to the fluid inlet at the corresponding viscosity of 45 mPa·s to 130 mPa·s. The corresponding viscosity provided to the fluid inlet may in turn provide the predefined jetting viscosity of the fluid when it enters the pressure chambers 10. The predefined jetting viscosity is the viscosity that is previously determined to be suitable for jetting. The predefined jetting viscosity may correspond to a predefined jetting temperature, for example as determined from measurements such as those provided in Table 2. The bold values of Table 2 show the temperatures and corresponding viscosities at which the fluids were jetted.

The droplet deposition head may further comprise a heater 58, 59 configured to heat the fluid to jetting temperature. Such a heater, heater 58, may be comprised within the fluid supply 40. Additionally, or instead, an onboard heater 59 may be provided within the printhead 30, the heater 59 being preferably located in close proximity and thermal contact to the pressure chambers 10.

From Figure 1 (and Table 1) it can be seen that the viscosity at jetting temperature for the high viscosity fluids may be much higher than the conventional viscosity range of up to and around 30 mPa·s. For these fluids, the viscosity at 30°C may be extremely high. In some cases therefore, the viscosity of the fluid at 30°C may lie in a range of 60 mPa·s to 660 mPa·s. A suitable jetting viscosity may be obtained by heating the fluid. Fluids A, B, F and G are High Viscosity Development Fluids formulated by BASF and it is expected that routine experimentation may identify suitable high viscosity fluids capable of being jetted at a suitable jetting viscosity, such as for Fluid A the viscosity of 656 mPa·s at 30°C drops to 65 mPa·s at 70°C and becomes jettable. Such fluids may for example be high molecular weight and/or particle loading variants of standard fluids and using standard solvents. Another example is shown by Fluid H, which has a relatively high viscosity of 182 mPa·s 30°C that drops to 48 mPa·s at 50°C. From the experiments therefore it was found that for fluids having a viscosity at 30°C that ranges from 60 to 660 mPa·s (or a viscosity at 20°C ranging from 30 mPa·s to 1392 mPa·s), each fluid has a corresponding viscosity at a temperature ranging from 20°C to 90°C in the range of 45 mPa·s (Fluid A at 90°C, Figure 1) to 120 mPa·s (Fluid C at 20°C, Figure 1). Similarly, from the experiments in Table 1, for fluids having a viscosity at 20°C ranging from 30 mPa·s to 1392 mPa·s, a temperature with a corresponding viscosity could be identified that allowed the fluid to be jetted; in this case a jetting temperature from 20°C to 90°C provided a selection of jettable viscosities in the range of 45 mPa·s (Fluid D, 42 mPa·s at 25°C, and which is also jettable at 20°C at a viscosity of 55 mPa·s) to 120 mPa·s (Fluid G, 108 mPa·s at 30°C, or Fluid F, 119 mPa·s at 35°C), or up to 130 mPa·s for Fluids A (125 mPa·s at 55°C), B (126 mPa·s at 45°C), C (126 mPa·s at 20°C) and H (129 mPa·s at 35°C).

Regarding the fluid path of the head, the fluid resistance as measured between the fluid inlet and the fluid return may be equal to or lower than 800 mbar/(ml·min) per fluid chamber. The pressure chambers for open ended designs pose the highest fluid resistance within the printhead. Such fluid resistances may be equal to or lower than those posed by a pressure chamber of constant cross sectional area of 0.0225 mm$^2$ (in the unactuated state) and having a chamber length of 1.8 mm, where the chamber length is along a direction perpendicular to the cross sectional area.

Furthermore, in some implementations of the head 30, the operation of the head may represent an efficient mode of operation, wherein the maximum peak to peak voltage of the drive signal is less than or equal to 35 V to eject a droplet of a volume between 7 to 120 pl at a droplet ejection velocity of 11 m/s. In some implementations, the peak to peak voltage may be less than 30 V to eject a droplet of a volume between 7 to 120 pl at a droplet ejection velocity of 11 m/s. Furthermore, in some implementations, the peak to peak voltage may be less than 20 V to eject a droplet of a volume between 7 to 120 pl at a droplet ejection velocity of 11 m/s.

**Viscosity gradient**

The rates of change of the viscosity curves were also assessed. These are plotted in Figure 2. It can be seen that the viscosity gradient decreases as the temperature of the fluid is increased, and that the standard fluids D, E drop below a gradient of 1 at temperatures around 35-40°C. The remaining high viscosity fluids drop below a gradient of 1 at temperatures around 50°C or higher. In particular, the high viscosity fluids A, B only drop below or reach a viscosity gradient less than 1 near the degradation limit of the fluid.

**Ohnesorge number**

The inventors have found a very strong relationship between reliable printing and the Ohnesorge number *Oh*. The Ohnesorge number is defined as:

$$Oh = \frac{\eta}{\sqrt{\rho \sigma L}} = \frac{\sqrt{We}}{Re} \sim \frac{viscous\ forces}{\sqrt{inertia \cdot surface\ tension}}$$

where

$\eta$ is the liquid viscosity

$\rho$ is the liquid density

$\sigma$ is the surface tension

$L$ is the characteristic length scale (typically drop diameter)

$Re$ is the Reynolds number

$We$ is the Weber number

**[0073]** The Reynolds number is defined as the ratio of the product of fluid density $\rho$, fluid velocity $v$ (in this case the drop velocity upon ejection) and characteristic linear dimension $L$ (in this case the nozzle diameter), and the dynamic viscosity $\eta$ of the fluid:

$$Re = \frac{\rho v L}{\eta}$$

The Weber number $We$ is a ratio of inertia forces and forces resulting from surface tension $\sigma$ of the fluid. It is defined as

$$We = \frac{\rho v^2 L}{\sigma}$$

whereas above $\rho$ is fluid density, v is fluid velocity (in this case the drop velocity upon ejection) and L is the characteristic linear dimension (in this case the nozzle diameter).

Ohnesorge numbers for each fluid at different temperatures can therefore be calculated and inputs and numbers are listed in Table 4. The values relate to a droplet ejection velocity of 11 m/s, and length scale L = 3.50 E$^{-05}$ m for the GS12 nozzle diameter.

Table 4: Figure 3 data

| Fluid | T, °C | $n_{jetting}$, mPa·s | $\rho$, g/cm$^3$ | $\sigma$, mN/m | $Oh$ | $Re$ | $We$ |
|---|---|---|---|---|---|---|---|
| A | 60 | 97 | 1.1003 | 38.4 | 2.52 | 4.4 | 121.2 |
| A | 67 | 72 | 1.1042 | 37.0 | 1.90 | 5.9 | 126.3 |
| A | 70 | 65 | 1.1058 | 36.4 | 1.73 | 6.6 | 128.5 |
| B | 45 | 126 | 1.0816 | 41.4 | 3.67 | 2.5 | 81.9 |
| B | 56 | 76 | 1.0735 | 40.2 | 1.95 | 5.5 | 113.1 |
| B | 70 | 48 | 1.0623 | 38.5 | 1.28 | 8.5 | 116.9 |
| C | 25 | 95 | 1.0783 | 51.8 | 2.16 | 4.4 | 88.2 |
| D | 45 | 17 | 1.0725 | 21.9 | 0.61 | 23.8 | 207.5 |
| E | 43 | 15 | 1.3429 | 31.3 | 0.38 | 35.7 | 181.9 |
| F | 50 | 58 | 1.0781 | 40.7 | 1.49 | 7.1 | 112.1 |
| F | 55 | 48 | 1.0779 | 40.2 | 1.22 | 8.7 | 113.5 |
| G | 55 | 34 | 1.0752 | 40.5 | 0.88 | 12.0 | 112.5 |
| H | 45 | 66 | 1.0431 | 37.4 | 1.79 | 6.07 | 118.1 |
| K | 27 | 88 | 1.1479 | 33.8 | 2.38 | 5.03 | 144.0 |
| K | 35 | 53 | 1.1422 | 32.9 | 1.47 | 8.25 | 147.0 |
| L | 30 | 63 | 1.1131 | 28.5 | 1.88 | 6.86 | 165.3 |
| M | 33 | 98 | 1.0890 | 36.7 | 2.62 | 4.27 | 125.6 |

Figure 3 is a plot of Weber number $We$ versus Reynolds number $Re$ for fluids A, B, C, D, E, F, G, H, K, L and M. A key to the fluids is found in Table 3. The three data points in the traditionally "good" region, the "printable fluid" region, are standard inkjet inks D, E (Itaca MA5115 and Sunjet ULX5832), and development fluid G of near-standard viscosity of 34 mPa·s. For these three inks, the Ohnesorge number is less than one, *Oh* < 1.

The data points from other successfully jetted fluids are located in the "too viscous" region to the left of the trendline of *Oh* = 1, i.e. for which *Oh* > 1, but all lie above the line indicated by trend line T1, signifying the "insufficient energy for drop formation" region. The trend line T2 represents the onset of "splashing", above which droplets break up into spray. To the right of the trendline *Oh* = 0.1, i.e. for which *Oh* < 0.1, satellites tend to form along with the ejected droplets and print quality deteriorates.

It was found that using the second drive mode (3-Cycle mode) in combination with a low resistance head such as a Xaar 1003 printhead, a range of fluids with Ohnesorge numbers 0.25 < *Oh* < 1.75 could be jetted. Using the first drive mode, the high laydown mode, fluid with even higher values of *Oh* could be jetted, in the range of 0.44 < *Oh* < 4. In other examples, fluids with the Ohnesorge numbers in the range of 0.44 < *Oh* < 3 or in the range of 0.44 < *Oh* < 2.5 may be jetted using the first drive mode.

In some implementations of the droplet deposition apparatus therefore, the fluid properties may be such that the Ohnesorge number of the fluid is greater than 1.5.

Where the droplet deposition apparatus is operated according to a first drive mode (or high laydown mode) as described above, the fluid within the chambers may have a viscosity within a range of 45 mPa·s up to and including 130 mPa·s at a jetting temperature between 20°C and 90°C. When using the first drive mode, such a fluid may have an Ohnesorge number greater than 0.44 and less than 2.5. In further examples, the fluid may have an Ohnesorge number greater than 0.44 but less than 4 or less than 3. Furthermore, the fluid may preferably have an Ohnesorge number greater than 1.5.

Alternatively, where the droplet deposition apparatus 1 is operated in a second, three cycle, drive mode, the fluid within the chambers 10 may have a viscosity within a range of 45 mPa·s up to and including 65 mPa·s at a jetting temperature between 20°C and 90°C. For such a fluid, the Ohnesorge number may be greater than 1 and less than 2, and furthermore the fluid may preferably have an Ohnesorge number greater than 1.5 and less than 2.

The first drive mode may have a maximum peak to peak drive voltage lower than that of the second drive mode to eject a droplet of the same velocity. In some implementations, the peak to peak voltage of the drive signal 60 between the first drive mode and the second drive mode may be 10 V for the same fluid at the same jetting viscosity and achieving the same droplet velocity.

## Fluid supply and droplet velocity

Fluid may be supplied to and from the printhead 30 via the inlet and return pipes 23, 25 in Figure 7.

The fluid supply 40 may for example comprise a heater 58 that may heat the fluid to a jetting temperature high enough to lower the viscosity to within a suitable range, for example suitable for the drive mode applied. Additionally, or instead, an onboard heater 59 may be provided onboard the printhead 30 in the vicinity of or at the layer comprising the fluid chambers 10 so as to provide and/or maintain the fluid at a stable jetting temperature.

It was found that when using drive modes such as the first mode, the high actuation rate of the piezoelectric walls 8 can cause significant heating of the walls and therefore of the fluid within the chambers. The actuation rate is typically represented by the duty cycle. The duty cycle represents the percentage of the nozzle ejections per cycle of the printhead. Increasing the duty cycle to eject more droplets means sending an increased number of drive signals to the actuators. This increases the heat generated within the piezoelectric walls 8. This generated heat is dissipated into the fluid in the fluid chambers, thereby heating the fluid and changing its physical properties, such as lowering the viscosity, and the location on the viscosity-temperature curve in Figure 1.

Going from low duty to high duty generally means that the viscosity of the fluid decreases, which instantaneously changes the Ohnesorge number of the fluid and can change the position of the drop stability due to a shift in the location on the Weber number-Reynolds number plot of Figure 3. Additionally, a decrease in viscosity increases the droplet velocity and thus can affect the landing position of the droplets, leading to a reduction in print quality.

Without managing or dissipating the heat generated due to the chamber wall actuations, printing reliability can be affected.

Therefore, it is desirable to control the droplet velocity dynamically (i.e. regularly during operation of the head) during changes in duty cycle so as to ensure a reliable print quality. This may be achieved by altering the drive voltage in response to changes in fluid temperature, which alters the droplet velocity. For example, a lower drive voltage reduces the droplet velocity. In addition, the actuating walls are driven less hard and the heat generated by the actuating walls is reduced also. The droplet velocity may be dynamically controlled by using a feedback loop between fluid temperature and drive voltage, the drop velocity, and to some extent the fluid temperature and viscosity, may be actively managed during operation of the printhead.

The power consumed by the drive signal generating circuitry to generate drive signals for the actuating chamber walls may be used as a measure of the heat generated by the actuating chamber walls. As the duty cycle is increased, for example, the current drawn by the drive signal generating circuitry to generate and increased number of drive signals increases. A measurement of the current drawn therefore provides a suitable measure of the effect of heating by the actuating walls on the fluid within the pressure chambers 10, and therefore of the expected increase in droplet velocity as the fluid in the chambers is heated instantaneously upon application of the higher duty cycle signals. Therefore, the current drawn by the drive signal generating circuitry 80 may be measured periodically and provided to the controller 54. The controller determines from the current value a new peak to peak voltage of the drive signal and provides the new value to drive signal generation circuitry 80. The drive signal generation circuitry 80 generates subsequent drive signals (and sub droplet signals) with the new peak to peak voltage, so as to ensure that the droplet velocity remains substantially equal to a predefined value for droplet velocity.

The predefined value for the droplet viscosity is a value previously determined as being suitable for the operation of the droplet deposition apparatus. Preferably, the velocity of the ejected droplets is kept close to or substantially equal to the predetermined droplet velocity so as to ensure reliable printing quality.

If the controller determines a reduced peak to peak voltage is to be applied, the resulting drive signals applying the reduced peak to peak voltage will also reduce the heat generated by the actuating walls and to some degree modify heating effect of the chamber walls on the fluid.

The adjustment of peak to peak voltage in response to the current drawn by the drive signal generation circuitry therefore may to some degree (albeit a lesser, compared to the effect on droplet velocity) be used to control the temperature of the fluid within the pressure chambers 10.

The controller 54 may compare the current value provided by the drive signal generation circuitry 80 to, for example, test data generated previously and stored in the form of a look up table accessible by the controller 54. From the look up table, the controller 54 selects a reduced peak to peak voltage value corresponding to the current value and the predefined droplet voltage, where the new peak to peak voltage has previously been determined in test runs to stabilise the droplet velocity for the new fluid viscosity expected to result from the measured current value. In this way, the droplet velocity remains stable, providing a reliably operating printhead.

In some implementations, the drive signal generation circuitry 80 may be located within the head control circuitry 56 of the printhead 30. In this case, the determination of the modified peak to peak value may be carried out by the head control circuitry on receipt of the measurement of the current drawn by the drive signal generation circuitry 80. The head control circuitry 56 selects a modified peak to peak voltage value corresponding to the current value and the predefined droplet voltage, and provides it to the drive signal generation circuitry 80.

In some implementations of droplet deposition apparatus using recirculating printheads, the return flow of ink may be used to carry away the heat generated by the actuating walls. For example, the feedback loop may exist between the printhead providing a temperature reading of the fluid, and the fluid supply which alters the recirculation rate in response.

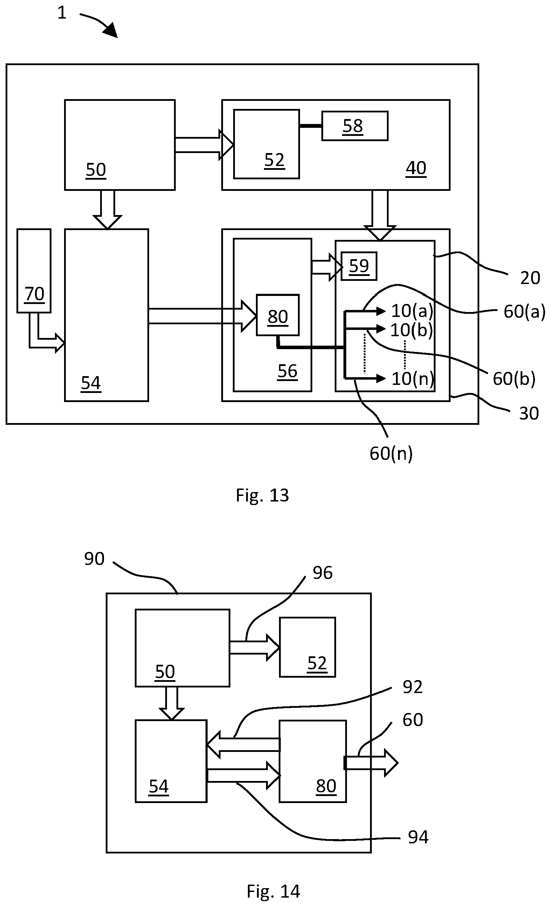

The droplet deposition apparatus comprising the low resistance printheads described above when operated with high viscosity fluids may be controlled by various components of a control system of the apparatus. These will now be described with reference to Figure 13, which is a block diagram of the droplet deposition apparatus 1, and Figure 14, which is a block diagram of the control system 90 for the droplet deposition apparatus.

Droplet deposition apparatus 1 comprises printhead 30, a user interface 50 such as a PC, a fluid supply 40 and a controller 54. The controller 54 receives image data from the user interface 50 and determines, for each pixel line, pixel clock triggers and sub droplet data for droplets to be ejected from the chambers 10 of the fluid component 20 within printhead 30. The controller supplies pixel clock triggers and sub droplet data to drive signal generation circuitry 80, comprised within the head control circuitry 56 of the printhead 30. The drive signal generating circuitry generates drive signals 60 for each pressure chamber 10 and provides them to the chambers 10(a) to 10(n) of the fluid component 20 comprised within the printhead 30. The fluid is supplied to the fluid component 20 from the fluid supply 40. The fluid supply 40 comprises a fluid supply controller 52 arranged to adapt the flow rate of fluid through the head, for example to provide a predetermined recirculation flow rate. The fluid supply controller 52 is configured to control pumps (not shown) within the fluid supply in order to apply the required differential pressure between the inlet and return pipes of the printhead 30. The required differential pressure values may be provided to the fluid supply controller 52 by the user interface 50.

More particularly, the control system 90 may comprise a fluid supply controller 52 for controlling a fluid supply configured to supply a fluid to the fluid inlet at a differential pressure as measured between the fluid inlet and the fluid return, wherein the fluid inlet path starts at the fluid inlet into the head, and ends in the one or more nozzles, and wherein the fluid return path starts at the one or more nozzles and ends in the fluid return of the head, and wherein the differential pressure applied by the fluid supply causes a fluid return flow into the fluid return at a rate of between 50 ml/min and 200 ml/min.

The fluid supply 40 may further comprise a heater 58 in thermal contact with the fluid so as to enable it to heat the ink to a predetermined temperature. The heater may be controlled by a heater controller comprised within the fluid supply 40, for example within the fluid supply controller 52. The user interface may provide a value of a predefined temperature to the heater controller that determines the temperature to which the fluid in the fluid supply is to be heated so as to ensure a predefined temperature of the fluid when it enters the pressure chambers 10.

Additionally, or instead, an onboard heater 59 may be provided within the printhead and in close proximity, and thermal contact with, the fluid in the pressure chambers or at a location near the inlets to the pressure chambers. The heater 59 may be controlled by a heater controller comprised within the head control circuitry 56. The user interface 50 may provide, for example via the controller 54, a value of a predefined temperature to the onboard heater controller that determines the amount of heat the heater is to provide so as to ensure a predefined temperature of the fluid inside the pressure chambers 10. The provision of heaters within the flow path of the fluid supports jetting of high viscosity fluids and ensures that they are kept at or above the jetting temperature of the fluid, to provide the fluid at the predefined jetting viscosity.

Figure 13 further shows a media encoder circuitry 70 comprised within the droplet deposition apparatus 1. The media encoder circuitry 70 provides pixel clock signals to the controller 54 to allow the controller to determine the timing, in the form of pixel clock triggers, and therefore correct placement, of droplets into pixel lines on the media. The pixel clock triggers are provided to the drive signal generation circuitry 80 which controls the provision of the drive signals to the actuating walls in response to the pixel clock triggers.

To stabilise the droplet velocity during changes in fluid temperature caused by changes in duty cycle, the droplet deposition apparatus 1 may therefore comprise a drive signal generating circuitry 80, wherein the controller 54 is configured to receive current values consumed by the drive signal generating circuitry 80, and to determine a modified peak to peak voltage of the drive signal 60 in response to the current value so as to modify the droplet velocity of the ejected droplets. The modified peak to peak voltage may then be provided to the drive signal generating circuitry, which generates subsequent drive signals having the modified peak to peak voltage. The drive signal generating circuitry 80 may therefore be configured to receive from the controller 54 the modified peak to peak voltage, and to generate drive signals 60 with the modified peak to peak voltage so as to modify the droplet velocity of the droplets ejected from the one or more nozzles of the one or more fluid chambers of the droplet deposition head. The controller may be further configured to apply the drive signal to the piezoelectric chamber walls such that the nozzle deposits droplets of a fluid having a viscosity in the range from 45 mPa·s to 130 mPa·s at the predefined jetting temperature between 20°C and 90°C.

In some implementations, the drive signal generating circuitry 80 may be comprised within a head control circuit 56. Furthermore, instead of the controller 54, the head control circuit 56 may be configured to receive current values consumed by the drive signal generating circuitry 80, and to determine a modified peak to peak voltage of the drive signal 60 in response to the current value so as to modify the droplet velocity of the ejected droplets. The modified peak to peak voltage may then be provided to the waveform generating circuitry 80, which generates subsequent drive signals 60 having the modified peak to peak voltage.

Furthermore, a method for operating the droplet deposition apparatus 1 is provided. The method comprises the steps of (i) supplying fluid to the fluid chambers 10 of the droplet deposition head 30 so as to cause a recirculation flow of fluid through each chamber 10 at a rate of between 50 ml/min and 200 ml/min; (ii) providing heating to the fluid before and/or after suppling the fluid to the fluid inlet 23 of the head, such that the fluid in the fluid chambers 10 is at a predefined jetting temperature of between 20°C and 90°C and corresponding to a viscosity in the range from 45 mPa·s to 130 mPa·s; and (iii) applying a drive signal 60 to the piezoelectric walls 8 of one or more of the chambers so as to eject some of the fluid supplied to the chambers in the form of one or more droplets, and returning excess fluid supplied to the chamber but not ejected to the fluid return 25 of the head 30 at a rate of between 50 ml/min and 200 ml/min.

The method may further comprise the step of providing to the controller 56 of the droplet deposition apparatus 1 a current signal based on the duty cycle of actuations of the chamber walls 8, wherein the controller 54, 56 determines a modified peak to peak voltage of the drive signal 60 in response to the current value so as to keep the droplet velocity of the ejected droplets substantially equal to the predefined droplet velocity. To avoid visible defects in the print reliability, the droplet velocity may be kept to within +/-1 V of the predefined droplet velocity.

The method may further comprise the step of heating the fluid in the fluid supply 40 so that the heated fluid arriving at the fluid chambers 10 is substantially equal to the predefined jetting temperature.

Alternatively, or instead, the method may further comprise the step of heating the fluid onboard the droplet deposition head 30 so that the heated fluid arriving at the fluid chambers 10 is substantially equal to the predefined temperature.

To avoid visible defects in the print reliability, the jetting temperature may be kept to within +/-1°C of the predefined temperature. In some implementations, the jetting temperature may be kept to within +/-0.5°C of the predefined temperature.

The methods may be carried out by the control system 90 of the droplet deposition apparatus 1. A block diagram of the control system in shown in Figure 14. The control system 90 comprises a controller 54 and a drive signal generating circuitry 80. The controller 54 is configured to receive the predefined droplet velocity and current values 92 from the drive signal generation circuitry 80, and to determine, based on stored test data, a modified peak to peak voltage in response to the current value and the predefined droplet velocity. The drive signal generating circuitry 80 is configured to receive the modified peak to peak voltage and to generate drive signals 60 with the modified peak to peak voltage 94, such that the generated drive signals 60 modify the droplet velocity of the ejected droplets. The generated drive signals 60 may modify the droplet velocity so that it is substantially equal to the predefined droplet velocity. To avoid visible defects in the print reliability, the droplet velocity may be kept to within +/-1 V of the predefined droplet velocity.

In the embodiment shown in the block diagram of Figure 14, the drive signal generating circuitry 80 may be onboard the printhead, although this is not essential.

In an alternative embodiment of the control system, the function of the controller 54 described above may be carried out instead by the head control circuitry 56, and an identical block diagram with controller 56 replacing controller 54 may be envisaged.

In some implementations, the control system may further comprise a heater 58, 59 and a heater controller 57, wherein the heater is configured to heat the fluid provided to the chambers 10, and the heater controller 57 is configured to receive operating data 96 from the controller 56, wherein the operating data is based on the predefined droplet velocity and the current value 92 of the drive signal generation circuitry 80, and wherein the heater controller 57 is further configured to control the heater based on the operating data 96 so as to heat the fluid in the chambers to substantially the predefined jetting temperature. The heater 58 may be located within the fluid supply 40, and the heater controller 57 may be comprised within the fluid supply controller 52. Additionally, or instead, the heater 59 may be located onboard the printhead 30, and the heater controller 57 may be comprised within the head control circuitry 56 of the printhead.

In some implementations, the drive signal generating circuitry 80 may be comprised within the head control circuitry 56. In other implementations, the drive signal generating circuitry 80 may be comprised within the controller 54.

It should be understood that references above and herein to droplet deposition apparatus comprise inkjet printers and references to droplet deposition heads comprise inkjet printheads. To avoid visible defects in the print reliability, the droplet velocity may be kept to within +/-1 V of the predefined droplet velocity. Additionally, or instead, the jetting temperature may be kept to within +/-1°C of the predefined temperature, and in some implementations, the jetting temperature may be kept to within +/-0.5°C of the predefined temperature.

In some implementations, the peak to peak voltage of the drive signal between the first drive mode and the second drive mode may be 10 V for the same fluid at the same jetting viscosity and achieving the same droplet velocity.

The present disclosure also provides a droplet deposition apparatus comprising a droplet deposition head, a fluid supply and a controller, wherein: the droplet deposition head comprises one or more fluid chambers each having a nozzle, a fluid inlet path having a fluid inlet into the head, and ending in the one or more nozzles, and a fluid return path starting at the one or more nozzles and ending in a fluid return of the head; each fluid chamber comprises two opposing chamber walls comprising piezoelectric material and deformable upon application of an electric drive signal so as to eject a fluid droplet from the nozzle; the fluid supply is configured to supply a fluid to the fluid inlet at a differential pressure as measured between the fluid inlet and the fluid return; and the controller is configured to apply a drive signal to the piezoelectric chamber walls such that the nozzle or nozzles deposit droplets of a fluid having a viscosity in the range from 45 mPa·s to 120 mPa·s at a jetting temperature between 20°C and 90°C, and wherein the differential pressure applied by the fluid supply causes a fluid return flow into the fluid return at a rate of between 50 ml/min and 200 ml/min. Optional or preferable features of such a droplet deposition apparatus are as described in relation to the embodiments above.

Also provided is a method for operating such a droplet deposition apparatus, the method comprising the steps of: supplying fluid to the fluid chambers of the droplet deposition head so as to cause a recirculation flow of fluid through each chamber at a rate greater than the ejection rate; providing heating to the fluid before and/or after suppling the fluid to the fluid inlet of the head, such that the fluid in the fluid chambers is at a predefined jetting temperature and corresponding to a viscosity in the range from 45 mPa·s to 120 mPa·s; and applying a drive signal to the piezoelectric walls of one or more of the chambers so as to eject some of the fluid supplied to the chambers in the form of one or more droplets, and returning excess fluid supplied to the chamber but not ejected to the fluid return of the head. Optional or preferable features of such a method are as described in relation to the embodiments above. A control system for carrying out such a method is also provided.

**Claims**

1. A droplet deposition apparatus (1) comprising a droplet deposition head (30), a fluid supply (40), a controller (54), and drive signal generating circuitry (80), wherein:

   the droplet deposition head (30) comprises one or more fluid chambers (10) each having a nozzle (6), a fluid inlet path having a fluid inlet (23) into the droplet deposition head (30), and ending in the one or more nozzles (6), and a fluid return path starting at the one or more nozzles (6) and ending in a fluid return (25) of the droplet deposition head (30);

each fluid chamber (10) comprises two opposing chamber walls (8) comprising piezoelectric material and deformable upon application of an electric drive signal (60) so as to eject a fluid droplet from the nozzle (6) in use; and the fluid supply (40) is configured to supply, in use, a fluid to the fluid inlet (23) at a differential pressure as measured between the fluid inlet (23) and the fluid return (25);

wherein the controller (54) is configured to apply drive signals to the piezoelectric chamber walls (8) such that, in use, the nozzle or nozzles (6) deposit droplets of fluid having a viscosity in the range from 45 mPa·s to 130 mPa·s at a predefined jetting temperature between 20°C and 90°C;

wherein the drive signal generating circuitry (80) is configured to modify the drive signals to control droplet velocity during changes in chamber wall actuation rate so as to keep the droplet velocity of the ejected droplets substantially equal to a predefined droplet velocity in use; and

wherein, in use, the differential pressure applied by the fluid supply (40) causes a fluid return flow into the fluid return (25) at a rate of between 50 ml/min and 200 ml/min.

2. The droplet deposition apparatus according to claim 1, wherein, in use, the fluid supply (40) is configured to heat the fluid to the respective temperature in the range of 20°C to 90°C and to provide the heated fluid to the fluid inlet (23) at the corresponding viscosity of 45 mPa·s to 130 mPa·s.

3. The droplet deposition apparatus according to claim 1 or claim 2, wherein the droplet deposition head (30) further comprises a heater (58; 59) configured to heat the fluid to jetting temperature in use.

4. The droplet deposition apparatus according to any one of claims 1 to 3, configured to deposit droplets of fluid having a viscosity at 30°C lying in a range of 60 mPa·s to 660 mPa·s.

5. The droplet deposition apparatus according to any one of claims 1 to 4, configured such that, in use, a fluid resistance between the fluid inlet (23) and the fluid return (25) is equal to or lower than 800 mbar/(ml·min) per fluid chamber (10).

6. The droplet deposition apparatus according to any one of claims 1 to 5, configured to deposit, in use, fluid having an Ohnesorge number greater than 1.5.

7. The droplet deposition apparatus according to any one of claims 1 to 6, wherein the drive signals are applied according to a first, high laydown, drive mode and the droplet deposition apparatus (1) is configured such that, in use, the fluid within the fluid chambers (10) has a viscosity within the range of 45 mPa·s up to and including 130 mPa·s at a jetting temperature between 20°C and 90°C.

8. The droplet deposition apparatus according to any one of claims 1 to 6, wherein the drive signals are applied according to a second, three cycle, drive mode and the droplet deposition apparatus (1) is configured such that, in use, the fluid within the fluid chambers (10) has a viscosity value within the range of 45 mPa·s up to and including 65 mPa·s at a jetting temperature between 20°C and 90°C.

9. The droplet deposition apparatus according to claim 8, configured to deposit, in use, droplets of fluid having an Ohnesorge number greater than 1 and less than 2.

10. The droplet deposition apparatus according to claim 7, configured to deposit, in use, droplets of fluid having an Ohnesorge number greater than 0.44 and less than 4.

11. The droplet deposition apparatus according to any one of claims 1 to 10, wherein the droplet deposition head (30) further comprises the drive signal generating circuitry (80), wherein the controller (54) is configured to receive current values consumed by the drive signal generating circuitry (80), and to determine a modified peak to peak voltage of the drive signal in response to the current value so as to modify the droplet velocity of the ejected droplets in use.

12. The droplet deposition apparatus according to claim 11, wherein the drive signal generating circuitry (80) is configured to receive from the controller (54) the modified peak to peak voltage, and to generate drive signals with the modified peak to peak voltage so as to modify the droplet velocity of the ejected droplets in use.

13. The droplet deposition apparatus according to any one of claims 1 to 12, wherein a first drive mode has a maximum peak to peak drive voltage lower than that of a second drive mode to eject a droplet of the same velocity in use.

14. A method for operating the droplet deposition apparatus (1) of any one of claims 1 to 13, the method comprising the steps of:

supplying fluid to the fluid chambers (10) of the droplet deposition head (30) so as to cause a recirculation flow of fluid through each fluid chamber (10) at a rate of between 50 ml/min and 200 ml/min;

providing heating to the fluid before and/or after suppling the fluid to the fluid inlet (23) of the droplet deposition head (30), such that the fluid in the fluid chambers (10) is at a predefined jetting temperature of between 20°C and 90°C and corresponding to a viscosity in the range from 45 mPa·s to 130 mPa·s; and

applying drive signals to the piezoelectric walls (8) of one or more of the fluid chambers (10) so as to eject some of the fluid supplied to the fluid chambers (10) in the form of one or more droplets having a viscosity in the range from 45 mPa·s to 130 mPa·s at a jetting temperature between 20°C and 90°C, and returning excess fluid supplied to the fluid chamber (10) but not ejected to the fluid return (25) of the head at a rate of between 50 ml/min and 200 ml/min;

wherein the drive signal generating circuitry (80) is configured to modify the drive signals to control droplet velocity during changes in chamber wall actuation rate so as to keep the droplet velocity of the ejected droplets substantially equal to a predefined droplet velocity.

15. The method according to claim 14, the method further comprising the drive signal generating circuitry (80) providing to the controller (54) a current signal based on a duty cycle of actuations of the chamber walls (8), wherein the controller (54) adjusts a peak to peak voltage of the drive signal in response to a current value so as to keep the droplet velocity of the ejected droplets substantially equal to the predefined droplet velocity.

16. A control system configured to carry out the method according to claim 14 or claim 15, the control system comprising the controller (54) and the drive signal generating circuitry (80), wherein the controller (54) is configured to receive the predefined droplet velocity and current values from the drive signal generating (80) circuitry, and to determine, based on stored test data, a modified peak to peak voltage in response to the current value and the predefined droplet velocity;

and wherein the drive signal generating circuitry (80) is configured to receive the modified peak to peak voltage and generate drive signals with the modified peak to peak voltage, such that, in use, the generated drive signals modify the droplet velocity of the droplets ejected from the one or more nozzles (6) of the one or more fluid chambers (10) of the droplet deposition head (30) so as to keep the droplet velocity of the ejected droplets substantially equal to the predefined droplet velocity;

and wherein the controller (54) is further configured to apply the drive signals to the piezoelectric chamber walls (8) such that, in use, the nozzle deposits droplets of a fluid having a viscosity in the range from 45 mPa·s to 130 mPa·s at the predefined jetting temperature between 20°C and 90°C.

17. The control system according to claim 16, further comprising a heater (58; 59) and a heater controller (57), wherein the heater (58; 59) is configured to heat the fluid provided to the fluid chambers (10) in use, and the heater controller (57) is configured to receive operating data (96) from the controller (54), wherein the operating data (96) is based on the predefined droplet velocity and the current value of the drive signal generation circuitry (80), the heater controller (57) further configured to control the heater (58; 59) based on the operating data so as to heat the fluid in the fluid chambers (10) to substantially the predefined jetting temperature in use.

**Patentansprüche**

1. Tröpfchenabscheidungsvorrichtung (1), die einen Tröpfchenabscheidungskopf (30), eine Fluidzufuhr (40), einen Controller (54) und eine Ansteuersignalerzeugungsschaltung (80) umfasst, wobei:

der Tröpfchenabscheidungskopf (30) eine oder mehrere Fluidkammern (10) umfasst, die jeweils Folgendes aufweisen: eine Düse (6), einen Fluideinlasspfad mit einem Fluideinlass (23) in den Tröpfchenabscheidungskopf (30), der in der einen oder den mehreren Düsen (6) endet, und einen Fluidrücklaufpfad, der an der einen oder den mehreren Düsen (6) beginnt und in einem Fluidrücklauf (25) des Tröpfchenablagerungskopfes (30) endet; jede Fluidkammer (10) zwei gegenüberliegende Kammerwände (8) umfasst, die piezoelektrisches Material umfassen und bei Anlegen eines elektrischen Ansteuersignals (60) verformbar sind, um im Gebrauch ein Fluidtröpfchen aus der Düse (6) auszustoßen; und

die Fluidzufuhr (40) dafür konfiguriert ist, im Gebrauch dem Fluideinlass (23) ein Fluid mit einem Differenzdruck zuzuführen, der zwischen dem Fluideinlass (23) und dem Fluidrücklauf (25) gemessen wird;

wobei der Controller (54) dafür konfiguriert ist, Ansteuersignale an die piezoelektrischen Kammerwände (8) anzulegen, so dass die Düse oder die Düsen (6) im Gebrauch Tröpfchen eines Fluids mit einer Viskosität im Bereich von 45 mPa·s bis 130 mPa·s bei einer vordefinierten Ausstoßtemperatur zwischen 20°C und 90°C abscheiden;

wobei die Ansteuersignalerzeugungsschaltung (80) dafür konfiguriert ist, die Ansteuersignale zu modifizieren, um die Tröpfchengeschwindigkeit während Änderungen der Kammerwandbetätigungsrate so zu steuern, dass die Tröpfchengeschwindigkeit der ausgestoßenen Tröpfchen im Gebrauch im Wesentlichen gleich einer vordefinierten Tröpfchengeschwindigkeit bleibt; und

wobei im Gebrauch der von der Fluidzufuhr (40) angelegte Differenzdruck einen Fluidrücklauffluss in den Fluidrücklauf (25) mit einer Rate zwischen 50 ml/min und 200 ml/min bewirkt.

2. Tröpfchenabscheidungsvorrichtung nach Anspruch 1, wobei die Fluidzufuhr (40) dafür konfiguriert ist, das Fluid auf die jeweilige Temperatur im Bereich von 20°C bis 90°C zu erhitzen und das erhitzte Fluid mit der entsprechenden Viskosität von 45 mPa·s bis 130 mPa·s dem Fluideinlass (23) zuzuführen.

3. Tröpfchenabscheidungsvorrichtung nach Anspruch 1 oder Anspruch 2, wobei der Tröpfchenabscheidungskopf (30) ferner eine Heizvorrichtung (58; 59) umfasst, die so konfiguriert ist, dass sie das Fluid im Gebrauch auf die Ausstoßtemperatur erhitzt.

4. Tröpfchenabscheidungsvorrichtung nach einem der Ansprüche 1 bis 3, die dafür konfiguriert ist, Tröpfchen eines Fluids abzuscheiden, deren Viskosität bei 30°C in einem Bereich von 60 mPa·s bis 660 mPa·s liegt.

5. Tröpfchenabscheidungsvorrichtung nach einem der Ansprüche 1 bis 4, die so konfiguriert ist, dass ein Fluidwiderstand zwischen dem Fluideinlass (23) und dem Fluidrücklauf (25) im Gebrauch gleich oder kleiner als 800 mbar/(ml-min) pro Fluidkammer (10) ist.

6. Tröpfchenabscheidungsvorrichtung nach einem der Ansprüche 1 bis 5, die so konfiguriert ist, dass sie im Gebrauch ein Fluid mit einer Ohnesorge-Zahl von mehr als 1,5 abscheidet.

7. Tröpfchenabscheidungsvorrichtung nach einem der Ansprüche 1 bis 6, wobei die Ansteuersignale nach einem ersten Ansteuermodus mit hoher Schichtdicke angelegt werden und die Tröpfchenabscheidungsvorrichtung (1) so konfiguriert ist, dass das Fluid in den Fluidkammern (10) im Gebrauch eine Viskosität im Bereich von 45 mPa·s bis zu und einschließlich 130 mPa·s bei einer Ausstoßtemperatur zwischen 20°C und 90°C aufweist.

8. Tröpfchenabscheidungsvorrichtung nach einem der Ansprüche 1 bis 6, wobei die Ansteuersignale nach einem zweiten, dreistufigen Ansteuermodus angelegt werden und die Tröpfchenabscheidungsvorrichtung (1) so konfiguriert ist, dass das Fluid in den Fluidkammern (10) im Gebrauch einen Viskositätswert im Bereich von 45 mPa·s bis zu und einschließlich 65 mPa·s bei einer Ausstoßtemperatur zwischen 20°C und 90°C aufweist.

9. Tröpfchenabscheidungsvorrichtung nach Anspruch 8, die so konfiguriert ist, dass sie im Gebrauch Fluidtröpfchen mit einer Ohnesorge-Zahl von mehr als 1 und weniger als 2 abscheidet.

10. Tröpfchenabscheidungsvorrichtung nach Anspruch 7, die so konfiguriert ist, dass sie im Gebrauch Fluidtröpfchen mit einer Ohnesorge-Zahl von mehr als 0,44 und weniger als 4 abscheidet.

11. Tröpfchenabscheidungsvorrichtung nach einem der Ansprüche 1 bis 10, wobei der Tröpfchenabscheidungskopf (30) ferner die Ansteuersignalerzeugungsschaltung (80) umfasst, wobei der Controller (54) dafür konfiguriert ist, Stromwerte zu empfangen, die von der Ansteuersignalerzeugungsschaltung (80) verbraucht werden, und eine modifizierte Spitze-zu-Spitze-Spannung des Ansteuersignals als Reaktion auf den Stromwert zu bestimmen, um die Tröpfchengeschwindigkeit der ausgestoßenen Tröpfchen im Gebrauch zu modifizieren.

12. Tröpfchenabscheidungsvorrichtung nach Anspruch 11, wobei die Ansteuersignalerzeugungsschaltung (80) dafür konfiguriert ist, von dem Controller (54) die modifizierte Spitze-zu-Spitze-Spannung zu empfangen, und Ansteuersignale mit der modifizierten Spitze-zu-Spitze-Spannung zu erzeugen, um die Tröpfchengeschwindigkeit der ausgestoßenen Tröpfchen im Gebrauch zu modifizieren.

13. Tröpfchenabscheidungsvorrichtung nach einem der Ansprüche 1 bis 12, wobei ein erster Ansteuerungsmodus eine maximale Spitze-zu-Spitze-Ansteuerspannung hat, die niedriger ist als die eines zweiten Ansteuerungsmodus, um ein Tröpfchen mit der gleichen Geschwindigkeit im Gebrauch auszustoßen.

14. Verfahren zum Betreiben der Tröpfchenabscheidungsvorrichtung (1) nach einem der Ansprüche 1 bis 13, wobei das Verfahren folgende Schritte umfasst:

Zuführen von Fluid zu den Fluidkammern (10) des Tröpfchenabscheidungskopfes (30), um einen Rezirkulationsstrom von Fluid durch jede Fluidkammer (10) mit einer Rate zwischen 50 ml/min und 200 ml/min zu erzeugen; Erhitzen des Fluids vor und/oder nach der Zuführung des Fluids zum Fluideinlass (23) des Tröpfchenabscheidungskopfes (30), so dass das Fluid in den Fluidkammern (10) eine vordefinierte Ausstoßtemperatur zwischen 20°C und 90°C hat und einer Viskosität im Bereich von 45 mPa·s bis 130 mPa·s entspricht; und Anlegen von Ansteuersignalen an die piezoelektrischen Wände (8) einer oder mehrerer der Fluidkammern (10), um einen Teil des den Fluidkammern (10) zugeführten Fluids in Form eines oder mehrerer Tröpfchen mit einer Viskosität im Bereich von 45 mPa·s bis 130 mPa·s bei einer Ausstoßtemperatur zwischen 20°C und 90°C auszustoßen, und Rückführen von überschüssigem Fluid, das der Fluidkammer (10) zugeführt, aber nicht ausgestoßen wurde, zum Fluidrücklauf (25) des Kopfes mit einer Rate zwischen 50 ml/min und 200 ml/min; wobei die Ansteuersignalerzeugungsschaltung (80) dafür konfiguriert ist, die Ansteuersignale zu modifizieren, um die Tröpfchengeschwindigkeit während Änderungen der Kammerwandbetätigungsrate so zu steuern, dass die Tröpfchengeschwindigkeit der ausgestoßenen Tröpfchen im Wesentlichen gleich einer vordefinierten Tröpfchengeschwindigkeit bleibt.

15. Verfahren nach Anspruch 14, wobei das Verfahren ferner umfasst, dass die Ansteuersignalerzeugungsschaltung (80) dem Controller (54) ein Stromsignal basierend auf einem Tastverhältnis der Betätigungen der Kammerwände (8) bereitstellt, wobei der Controller (54) eine Spitze-zu-Spitze-Spannung des Ansteuersignals als Reaktion auf einen Stromwert so einstellt, dass die Tröpfchengeschwindigkeit der ausgestoßenen Tröpfchen im Wesentlichen gleich der vordefinierten Tröpfchengeschwindigkeit bleibt.

16. Steuerungssystem, das dafür konfiguriert ist, das Verfahren nach Anspruch 14 oder Anspruch 15 auszuführen, wobei das Steuerungssystem den Controller (54) und die Ansteuersignalerzeugungsschaltung (80) umfasst, wobei der Controller (54) dafür konfiguriert ist, die vordefinierte Tröpfchengeschwindigkeit und die Stromwerte von der Ansteuersignalerzeugungsschaltung (80) zu empfangen, und basierend auf gespeicherten Testdaten eine modifizierte Spitze-zu-Spitze-Spannung als Reaktion auf den Stromwert und die vordefinierte Tröpfchengeschwindigkeit zu bestimmen;

und wobei die Ansteuersignalerzeugungsschaltung (80) dafür konfiguriert ist, die modifizierte Spitze-zu-Spitze-Spannung zu empfangen und Ansteuersignale mit der modifizierten Spitze-zu-Spitze-Spannung zu erzeugen, so dass im Gebrauch die erzeugten Ansteuersignale die Tröpfchengeschwindigkeit der aus der einen oder den mehreren Düsen (6) der einen oder den mehreren Fluidkammern (10) des Tröpfchenabscheidungskopfes (30) ausgestoßenen Tröpfchen so modifizieren, dass die Tröpfchengeschwindigkeit der ausgestoßenen Tröpfchen im Wesentlichen gleich der vordefinierten Tröpfchengeschwindigkeit bleibt; und wobei der Controller (54) ferner dafür konfiguriert ist, die Ansteuersignale an die piezoelektrischen Kammerwände (8) anzulegen so dass die Düse im Gebrauch Tröpfchen eines Fluids mit einer Viskosität im Bereich von 45 mPa·s bis 130 mPa·s bei der vordefinierten Ausstoßtemperatur zwischen 20°c und 90°C abscheidet.

17. Steuerungssystem nach Anspruch 16, das ferner eine Heizvorrichtung (58; 59) und einen Controller (57) der Heizvorrichtung umfasst, wobei die Heizvorrichtung (58; 59) dafür konfiguriert ist, das den Fluidkammern (10) zugeführte Fluid im Gebrauch zu erwärmen, und der Controller (57) der Heizvorrichtung dafür konfiguriert ist, Betriebsdaten (96) von dem Controller (54) zu empfangen, wobei die Betriebsdaten (96) auf der vordefinierten Tröpfchengeschwindigkeit und dem Stromwert der Ansteuersignalerzeugungsschaltung (80) basieren, wobei der Controller (57) der Heizvorrichtung ferner dafür konfiguriert ist, die Heizvorrichtung (58; 59) basierend auf den Betriebsdaten so zu steuern, dass das Fluid in den Fluidkammern (10) im Gebrauch im Wesentlichen auf die vordefinierte Ausstoßtemperatur erwärmt wird.

## Revendications

1. Appareil de dépôt de gouttelettes (1) comprenant une tête de dépôt de gouttelettes (30), une alimentation en fluide (40), un contrôleur (54) et des circuits de génération de signaux de commande (80), dans lequel :

la tête de dépôt de gouttelettes (30) comprend une ou plusieurs chambres à fluide (10) présentant chacune une buse (6), un chemin d'entrée de fluide présentant une entrée de fluide (23) dans la tête de dépôt de gouttelettes (30) et se terminant dans les une ou plusieurs buses (6), et un chemin de retour de fluide commençant au niveau des une ou plusieurs buses (6) et se terminant dans un retour de fluide (25) de la tête de dépôt de gouttelettes (30) ;

chaque chambre à fluide (10) comprend deux parois de chambre opposées (8) comprenant un matériau piézoélectrique et déformables par application d'un signal de commande électrique (60) de manière à éjecter une gouttelette de fluide de la buse (6) en cours d'utilisation ; et

l'alimentation en fluide (40) est configurée pour, en cours d'utilisation, alimenter en fluide l'entrée de fluide (23) à une pression différentielle mesurée entre l'entrée de fluide (23) et le retour de fluide (25) ;

dans lequel le contrôleur (54) est configuré pour appliquer des signaux de commande aux parois de chambre piézoélectriques (8) de telle sorte que, en cours d'utilisation, les une ou plusieurs buses (6) déposent des gouttelettes de fluide d'une viscosité comprise entre 45 mPa·s et 130 mPa·s à une température de jet prédéfinie comprise entre 20 °C et 90 °C ;

dans lequel les circuits de génération de signaux de commande (80) sont configurés pour modifier les signaux de commande afin de réguler la vélocité de gouttelette durant des changements du taux d'actionnement des parois de chambre, de manière à maintenir la vélocité de gouttelette des gouttelettes éjectées sensiblement égale à une vélocité de gouttelette prédéfinie en cours d'utilisation ; et

dans lequel, en cours d'utilisation, la pression différentielle appliquée par l'alimentation en fluide (40) provoque un flux de retour de fluide dans le retour de fluide (25) à un débit compris entre 50 ml/min et 200 ml/min.

2. Appareil de dépôt de gouttelettes selon la revendication 1, dans lequel, en cours d'utilisation, l'alimentation en fluide (40) est configurée pour chauffer le fluide à la température respective dans la plage de 20 °C à 90 °C et fournir le fluide chauffé à l'entrée de fluide (23) à la viscosité correspondante de 45 mPa·s à 130 mPa·s.

3. Appareil de dépôt de gouttelettes selon la revendication 1 ou la revendication 2, dans lequel la tête de dépôt de gouttelettes (30) comprend en outre un élément chauffant (58 ; 59) configuré pour chauffer le fluide à la température de jet en cours d'utilisation.

4. Appareil de dépôt de gouttelettes selon l'une quelconque des revendications 1 à 3, configuré pour déposer des gouttelettes de fluide d'une viscosité à 30 °C comprise dans une plage de 60 mPa·s à 660 mPa·s.

5. Appareil de dépôt de gouttelettes selon l'une quelconque des revendications 1 à 4, configuré de telle sorte que, en cours d'utilisation, une résistance de fluide entre l'entrée de fluide (23) et le retour de fluide (25) soit égale ou inférieure à 800 mbar/(ml·min) par chambre à fluide (10).

6. Appareil de dépôt de gouttelettes selon l'une quelconque des revendications 1 à 5, configuré pour déposer, en cours d'utilisation, un fluide ayant un nombre d'Ohnesorge supérieur à 1,5.

7. Appareil de dépôt de gouttelettes selon l'une quelconque des revendications 1 à 6, dans lequel les signaux de commande sont appliqués selon un premier mode de commande de dépôt élevé, et l'appareil de dépôt de gouttelettes (1) est configuré de telle sorte que, en cours d'utilisation, le fluide à l'intérieur des chambres à fluide (10) ait une viscosité comprise dans la plage de 45 mPa·s à 130 mPa·s inclus à une température de jet comprise entre 20 °C et 90 °C.

8. Appareil de dépôt de gouttelettes selon l'une quelconque des revendications 1 à 6, dans lequel les signaux de commande sont appliqués conformément à un deuxième mode de commande à trois cycles, et l'appareil de dépôt de gouttelettes (1) est configuré de telle sorte que, en cours d'utilisation, le fluide à l'intérieur des chambres à fluide (10) ait une valeur de viscosité comprise entre 45 mPa·s et 65 mPa·s inclus à une température de jet comprise entre 20 °C et 90 °C.

9. Appareil de dépôt de gouttelettes selon la revendication 8, configuré pour déposer, en cours d'utilisation, des gouttelettes de fluide ayant un nombre d'Ohnesorge supérieur à 1 et inférieur à 2.

10. Appareil de dépôt de gouttelettes selon la revendication 7, configuré pour déposer, en cours d'utilisation, des gouttelettes de fluide ayant un nombre d'Ohnesorge supérieur à 0,44 et inférieur à 4.

11. Appareil de dépôt de gouttelettes selon l'une quelconque des revendications 1 à 10, dans lequel la tête de dépôt de gouttelettes (30) comprend en outre les circuits de génération de signaux de commande (80), dans lequel le contrôleur (54) est configuré pour recevoir des valeurs de courant consommé par les circuits de génération de signaux de commande (80), et pour déterminer une tension crête-crête modifiée du signal de commande en réponse à la valeur de courant de manière à modifier la vélocité de gouttelette des gouttelettes éjectées en usage.

12. Appareil de dépôt de gouttelettes selon la revendication 11, dans lequel les circuits de génération de signaux de commande (80) sont configurés pour recevoir à partir du contrôleur (54) la tension crête-crête modifiée et générer des signaux de commande avec la tension crête-crête modifiée de manière à modifier la vélocité de gouttelette des gouttelettes éjectées en cours d'utilisation.

13. Appareil de dépôt de gouttelettes selon l'une quelconque des revendications 1 à 12, dans lequel un premier mode de commande a une tension de commande crête-crête maximale inférieure à celle d'un deuxième mode de commande pour éjecter une gouttelette de la même vélocité en cours d'utilisation.

14. Procédé de fonctionnement de l'appareil de dépôt de gouttelettes (1) selon l'une quelconque des revendications 1 à 13, le procédé comprenant les étapes suivantes :

l'alimentation en fluide des chambres à fluide (10) de la tête de dépôt de gouttelettes (30) de manière à provoquer un flux de recyclage de fluide à travers chaque chambre à fluide (10) à un débit compris entre 50 ml/min et 200 ml/min ;

le chauffage du fluide avant et/ou après l'alimentation en fluide de l'entrée de fluide (23) de la tête de dépôt de gouttelettes (30), de telle sorte que le fluide dans les chambres à fluide (10) se trouve à une température de jet prédéfinie comprise entre 20 °C et 90 °C et correspondant à une viscosité comprise entre 45 mPa·s et 130 mPa.s ; et

l'application de signaux de commande sur les parois piézoélectriques (8) d'une ou plusieurs chambres à fluide (10) de manière à éjecter une partie du fluide alimenté dans les chambres à fluide (10) sous la forme d'une ou plusieurs gouttelettes d'une viscosité comprise entre 45 mPa·s et 130 mPa·s à une température de jet comprise entre 20 °C et 90 °C, et le retour de l'excès de fluide alimenté dans la chambre à fluide (10) mais non éjecté vers le retour de fluide (25) de la tête à un débit compris entre 50 ml/min et 200 ml/min ;

dans lequel les circuits de génération de signaux de commande (80) sont configurés pour modifier les signaux de commande afin de réguler la vélocité de gouttelette durant des changements de taux d'actionnement des parois de chambre de manière à maintenir la vélocité de gouttelette des gouttelettes éjectées sensiblement égale à une vélocité de gouttelette prédéfinie.

15. Procédé selon la revendication 14, le procédé comprenant en outre la fourniture par les circuits de génération de signaux de commande (80) au contrôleur (54) d'un signal de courant basé sur un rapport cyclique d'actionnements des parois de chambre (8), dans lequel le contrôleur (54) ajuste une tension crête à crête du signal de commande en réponse à une valeur de courant de manière à maintenir la vélocité de gouttelette des gouttelettes éjectées sensiblement égale à la vélocité de gouttelette prédéfinie.

16. Système de commande configuré pour entreprendre le procédé selon la revendication 14 ou la revendication 15, le système de commande comprenant le contrôleur (54) et les circuits de génération de signaux de commande (80), dans lequel le contrôleur (54) est configuré pour recevoir la valeur de vélocité de gouttelette prédéfinie et la valeur de courant à partir des circuits de génération de signaux de commande (80), et déterminer, en fonction de données de test stockées, une tension crête-crête modifiée en réponse à la valeur de courant et à la vélocité de gouttelette prédéfinie ;

et dans lequel les circuits de génération de signaux de commande (80) sont configurés pour recevoir la tension crête-crête modifiée et générer des signaux de commande avec la tension crête-crête modifiée, de telle sorte que, en cours d'utilisation, les signaux de commande générés modifient la vélocité de gouttelette des gouttelettes éjectées par les une ou plusieurs buses (6) des une ou plusieurs chambres à fluide (10) de la tête de dépôt de gouttelettes (30) de manière à maintenir la vélocité de gouttelette des gouttelettes éjectées sensiblement égale à la vélocité de gouttelette prédéfinie ;

et dans lequel le contrôleur (54) est configuré en outre pour appliquer les signaux de commande aux parois de chambre piézoélectrique (8) de telle sorte que, en cours d'utilisation, la buse dépose des gouttelettes d'un fluide d'une viscosité comprise entre 45 mPa·s et 130 mPa·s à la température de jet prédéfinie comprise entre 20 °C et 90 °C.

**17.** Système de commande selon la revendication 16, comprenant en outre un élément de chauffage (58 ; 59) et un régulateur d'élément de chauffage (57), dans lequel l'élément de chauffage (58 ; 59) est configuré pour chauffer le fluide alimentant les chambres à fluide (10) utilisées, et le régulateur d'élément de chauffage (57) est configuré pour recevoir des données de fonctionnement (96) à partir du contrôleur (54), dans lequel les données de fonctionnement (96) sont basées sur la vélocité de gouttelette prédéfinie et la valeur de courant des circuits de génération de signaux de commande (80), le régulateur d'élément de chauffage (57) étant configuré en outre pour réguler l'élément de chauffage (58 ; 59) en fonction des données de fonctionnement de manière à chauffer le fluide dans les chambres à fluide (10) à sensiblement la température de jet prédéfinie en cours d'utilisation.

Fig. 1

Fig. 2

Fig. 3

Fig. 4

Fig. 5

Fig. 6

Fig. 7

10(b)    10(d)    10(f)    10(h)    10(j)    10(l)    10(n)
10(a)    10(c)    10(e)    10(g)    10(i)    10(k)    10(m)

Fig. 8(a)

Fig. 8(b)

Fig. 9a

Encoder input

PCLK

10(a)

10(b)

10(c)

10(d)

10(e)

Fig. 9b

10(b)    10(d)    10(f)    10(h)    10(j)    10(l)    10(n)
10(a)    10(c)    10(e)    10(g)    10(i)    10(k)    10(m)

Fig. 10(a)

Fig. 10(b)

EP 3 972 845 B1

Fig. 11 (a)

Fig. 11 (b)

Fig. 11 (c)

Fig. 12

Fig. 13

Fig. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006075477 A1
- US 2010165020 A1
- EP 3330329 A2
- WO 0038928 A
- WO 0029217 A
- EP 0277703 A1
- WO 2018224821 A
- WO 2019058143 A